(19)

Europäisches Patentamt

European Patent Office

Office européen des brevets

(11) **EP 3 828 753 A1**

(12) **EUROPÄISCHE PATENTANMELDUNG**

(43) Veröffentlichungstag:
**02.06.2021   Patentblatt 2021/22**

(51) Int Cl.:
**G06G 7/16** *(2006.01)*      **H03F 3/45** *(2006.01)*

(21) Anmeldenummer: **20210397.4**

(22) Anmeldetag: **27.11.2020**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
**KH MA MD TN**

(30) Priorität: **28.11.2019   DE 102019218434**

(71) Anmelder: **FRAUNHOFER-GESELLSCHAFT zur Förderung**
**der angewandten Forschung e.V.**
**80686 München (DE)**

(72) Erfinder: **Pollak, Markus**
**91058 Erlangen (DE)**

(74) Vertreter: **Burger, Markus et al**
**Schoppe, Zimmermann, Stöckeler**
**Zinkler, Schenk & Partner mbB**
**Patentanwälte**
**Radlkoferstraße 2**
**81373 München (DE)**

(54)      **ANALOGRECHENSCHALTUNG**

(57)      Eine Analogrechenschaltung ist ausgelegt, um eine Gate-Source-Spannung $(U_{GS})$ eines ausgangsseitigen Feldeffekttransistors $(120;T1\_2; T2\_2)$, der in einem linearen Bereich betrieben wird, in Abhängigkeit von zumindest einem Eingangssignal $(110;VINA, V_{INA},VREF, V_{REF})$ einzustellen. Die Analogrechenschaltung ist ausgelegt, um ein Ausgangssignal $(114;VOUT, V_{OUT})$ in Abhängigkeit von einem Stromfluss $(I_D)$ durch den ausgangsseitigen Feldeffekttransistor $(T1\_2;T2\_2)$ zu erhalten, wobei eine Drain-Source-Spannung $(V_{GS};U_{GS})$ des ausgangsseitigen Feldeffekttransistors durch ein zweites Eingangssignal $(114;VINB,V_{INB})$ bestimmt wird. Alternativ ist die Analogrechenschaltung ausgelegt, um ein Ausgangssignal $(114; VOUT, V_{OUT})$ in Abhängigkeit von einer Drain-Source-Spannung $(V_{DS}; U_{DS})$ des ausgangsseitigen Feldeffekttransistors $(120;T1\_2;T2\_2)$ zu erhalten, wobei ein Drainstrom $(I_D)$ des ausgangsseitigen Feldeffekttransistors $(120;T1\_2; T2\_2)$ durch ein zweites Eingangssignal $(114;VINB,V_{INB})$ bestimmt wird.

Fig. 1

EP 3 828 753 A1

**Beschreibung**

Technisches Gebiet

Ausführungsbeispiele gemäß der vorliegenden Erfindung beziehen sich auf eine Analogrechenschaltung.
Insbesondere beziehen sich Ausführungsbeispiele der vorliegenden Erfindung auf eine analoge Schaltung zur Multiplikation bzw. Division von Signalen.

Hintergrund der Erfindung

Die Multiplikation bzw. Division von elektrischen Signalen wird in vielen technischen Anwendungsbereichen benötigt. Im Hinblick auf die Aufgabenstellung bestehen bereits verschiedene bisherige Problemlösungen, die im Folgenden erläutert werden.
Eine erste bisherige Problemlösung ist eine Gilbertzelle.

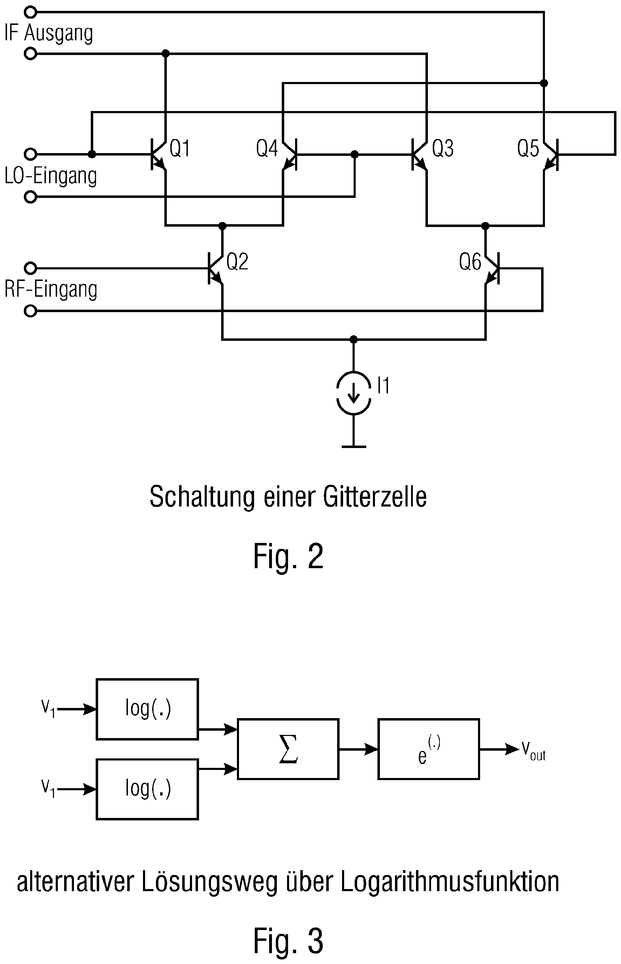

Fig. 2 zeigt ein Schaltbild einer Gilbertzelle. In anderen Worten, Fig. 2 zeigt eine Standardlösung zur Multiplizierung bzw. Modulation von Signalen, die besonders in der Hochfrequenztechnik zum Einsatz kommt, die sogenannte "Gilbertzelle". Die Gilbertzelle ist ähnlich einer Differenzverstärkerschaltung aufgebaut, wobei ausgenutzt wird, dass ihre Verstärkung durch den Betriebsstrom gesteuert werden kann. Dieser Strom kann über einen zweiten Eingang geregelt werden, wodurch sich im Prinzip die Multiplikation der beiden Eingangssignale ergibt.
In der gezeigten Anordnung gemäß Fig. 2 bezeichnet RF-Eingang einen Hochfrequenzeingang, LO-Eingang einen Lokaloszillatoreingang und IF-Ausgang einen Zwischenfrequenzausgang.
Eine logarithmische Operationsverstärkerschaltung bildet eine zweite bisherige Problemlösung. In anderen Worten, eine weitere Standardmöglichkeit, in der Analogtechnik Signale zu multiplizieren, besteht in dem Umweg über die Logarithmusfunktion. Fig. 3 zeigt eine schematische Darstellung dieses alternativen Lösungswegs über die Logarithmusfunktion. Dabei wird, wie in der Fig. 3 gezeigt, ausgenutzt, dass der Logarithmus zweier multiplizierter Größen a und b gleich der Summe der einzelnen logarithmierten Größen ist, also gemäß log(ab) = log(a) + log(b). Dies gilt auch für den natürlichen Logarithmus, der mit Operationsverstärkern und Dioden leicht aus einem Signal gebildet werden kann. Zusätzlich braucht man hier eine oder mehrere Operationsverstärkerschaltungen, die die e-Funktion abbilden können - um die logarithmierten Signale zurückzuwandeln - und eine Summiererschaltung. Letztlich muss also folgende Funktion umgesetzt werden, um aus den Eingangssignalen a und b auf das gewünschte Ausgangssignal x zu kommen:

$$x = e^{\ln(a)+\ln(b)}.$$

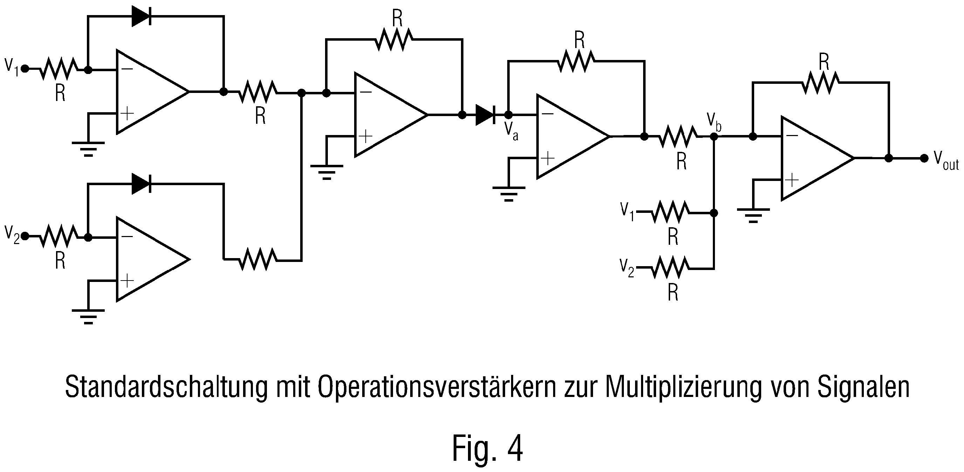

Fig. 4 zeigt ein Schaltbild einer Standardschaltung mit Operationsverstärkern zur Multiplikation von Signalen. In anderen Worten, Fig. 4 zeigt eine komplette Umsetzung der beschriebenen Schaltung, wobei zusätzlich ein Schaltungsteil benötigt wird, der die Anteile der Eingangssignale vom Ausgang entfernt. Im Endeffekt werden für die Lösung fünf Operationsverstärker benötigt.
Eine weitere bisherige Problemlösung besteht in der Verwendung einer digitalen Signalverarbeitung. Die Nutzung von digitaler Signalverarbeitung ist eine weitere Möglichkeit, mathematische Operationen auf elektrische Größen anzuwenden. Hierfür braucht es aber eine Recheneinheit und Schaltungsbausteine zur Analog-Digital- und Digital-Analog-Wandlung. Solche Lösungen werden oft als komplette integrierte Schaltung angeboten. Aufgrund der Komplexität der digitalen Lösungsvariante wird hier der Stromverbrauch allerdings entsprechend hoch ausfallen.
In Anbetracht der oben erläuterten bisherigen Problemlösungen besteht ein Bedarf an einer Schaltung, die einen verbesserten Kompromiss zwischen dem Implementierungsaufwand, einem Stromverbrauch und einer Qualität der Ausgangssignale liefert.

Zusammenfassung der Erfindung

Ein Ausführungsbeispiel gemäß der vorliegenden Erfindung schafft eine Analogrechenschaltung, zum Beispiel eine Multipliziererschaltung und/oder Dividiererschaltung. Die Analogrechenschaltung (zum Beispiel Multipliziererschaltung und/oder Dividiererschaltung) ist ausgelegt, um eine Gate-Source-Spannung eines ausgangsseitigen Feldeffekttransistors, der in einem linearen Bereich betrieben wird, in Abhängigkeit von zumindest einem Eingangssignal einzustellen. Die Analogrechenschaltung ist ferner ausgelegt, um ein Ausgangssignal in Abhängigkeit von einem Stromfluss durch den ausgangsseitigen Feldeffekttransistor zu erhalten, wobei eine Drain-Source-Spannung des ausgangsseitigen Feldeffekttransistors durch ein zweites Eingangssignal bestimmt wird. Alternativ dazu kann die Analogrechenschaltung ausgelegt sein, um ein Ausgangssignal in Abhängigkeit von einer Drain-Source-Spannung des ausgangsseitigen Feldeffekttransistors zu erhalten, wobei ein Drain-Strom des ausgangsseitigen Feldeffekttransistors durch ein zweites Eingangssignal bestimmt wird.

Dieses Ausführungsbeispiel gemäß der vorliegenden Erfindung basiert auf der Erkenntnis, dass bei einem Feldeffekttransistor, der in einem linearen Bereich betrieben wird, der Stromfluss (also typischerweise der Drainstrom) eine im Wesentlichen lineare Abhängigkeit von der Drain-Source-Spannung hat, wobei der Zusammenhang zwischen der Drain-Source-Spannung und dem Drain-Strom durch die Gate-Source-Spannung einstellbar ist. Somit wird beispielsweise - zumindest in guter Näherung - durch die Gate-Source-Spannung des ausgangsseitigen Feldeffekttransistors das Verhältnis zwischen Drain-Source-Spannung und Drainstrom des ausgangsseitigen Feldeffekttransistors eingestellt, so dass effektiv das Verhältnis zwischen der Drain-Source-Spannung des ausgangsseitigen Feldeffekttransistors und dem Drainstrom des ausgangsseitigen Feldeffekttransistors durch das erste Eingangssignal eingestellt wird. Dadurch kann beispielsweise durch eine entsprechende Einstellung der Gate-Source-Spannung des ausgangsseitigen Feldeffekttransistors erreicht werden, dass das Verhältnis zwischen der Drain-Source-Spannung des ausgangsseitigen Feldeffekttransistors und dem Drainstrom des ausgangsseitigen Feldeffekttransistors oder das Verhältnis zwischen dem Drainstrom des ausgangsseitigen Feldeffekttransistors und der Drain-Source-Spannung des ausgangsseitigen Feldeffekttransistors eine lineare Abhängigkeit von dem ersten Eingangssignal aufweist. Indem ferner beispielsweise die Drain-Source-Spannung des ausgangsseitigen Feldeffekttransistors (oder alternativ der Drainstrom des ausgangsseitigen Feldeffekttransistors) durch das zweite Eingangssignal bestimmt wird, kann somit erreicht werden, dass der Drainstrom des ausgangsseitigen Feldeffekttransistors (oder alternativ die Drain-Source Spannung) beispielsweise proportional zu dem zweiten Eingangssignal ist und/oder eine lineare Abhängigkeit von dem zweiten Eingangssignal aufweist (wenn ein konstantes erstes Eingangssignal angenommen wird). Dementsprechend kann erreicht werden, dass das Ausgangssignal, das in Abhängigkeit von dem Drainstrom des ausgangsseitigen Feldeffekttransistors (oder alternativ in Abhängigkeit von der Drain-Source-Spannung) gebildet wird, eine Abhängigkeit von einem Produkt der beiden Eingangssignale oder eine Abhängigkeit von einem Quotienten der beiden Eingangssignale aufweist (bzw. ein Produkt oder einen Quotienten der beiden Eingangssignale darstellt).

In anderen Worten, das erfindungsgemäße Konzept nutzt den im Wesentlichen linearen Zusammenhang zwischen Drain-Source-Spannung und Drainstrom des ausgangsseitigen Feldeffekttransistors aus, das sich - zumindest näherungsweise - in einem "linearen Betriebsbereich" des ausgangsseitigen Feldeffekttransistors ergibt, also beispielsweise wenn die Drain-Source-Spannung vergleichsweise klein ist.

Weiterhin basiert das Erfindungskonzept darauf, dass dieses Verhältnis zwischen Drain-Source-Spannung und Drainstrom des ausgangsseitigen Feldeffekttransistors durch das erste Eingangssignal steuerbar bzw. "modulierbar" ist, indem beispielsweise die Gate-Source-Spannung des ausgangsseitigen Feldeffekttransistors abhängig von dem ersten Eingangssignal variiert wird.

Ein wichtiges Merkmal des vorliegenden Erfindungskonzepts besteht im Übrigen darin, dass der ausgangsseitige Feldeffekttransistor - anders als bei verschiedenen herkömmlichen Schaltungen - nicht im Sättigungsbereich (z.B. bei $U_{DS} > U_{GS} - U_{TH}$ im Falle einen N-Kanal-Feldeffekttransistors, wobei $U_{DS}$ die Drain-Source-Spannung ist, wobei $U_{GS}$ die Gate-Source-Spannung ist, und wobei $U_{TH}$ die Schwellenspannung ist) betrieben wird, sondern in einem linearen Bereich (z.B. bei $U_{DS} < U_{GS} - U_{TH}$, oder bei $U_{DS} < 0.5 \cdot (U_{GS} - U_{TH})$ oder $U_{DS} < 0{,}25(U_{GS} - U_{TH})$), in dem eine näherungsweise lineare Abhängigkeit zwischen der Drain-Source-Spannung und dem Drainstrom besteht.

Im Übrigen weist das Erfindungskonzept eine Reihe von Vorteilen gegenüber herkömmlichen Erfindungskonzepten auf. Indem die speziellen Eigenschaften des Feldeffekttransistors in dem linearen Betriebsbereich ausgenutzt werden, kann die Komplexität der Schaltung vergleichsweise gering gehalten werden. Insbesondere kann auch von einem Übergang zu einer digitalen Signalverarbeitung abgesehen werden, und es können trotzdem gute Verarbeitungsergebnisse erzielt werden.

Bei einem bevorzugten Ausführungsbeispiel weist die Analogrechenschaltung einen eingangsseitigen Feldeffekttransistor auf. Vorzugsweise ist die Analogrechenschaltung so ausgelegt, dass Temperaturen, auf denen sich der eingangsseitige Feldeffekttransistor und der ausgangsseitige Feldeffekttransistor befinden, gleich sind bzw. zumindest näherungsweise gleich sind, sich also beispielsweise um höchstens 2 Kelvin oder 5 Kelvin oder 10 Kelvin unterscheiden. Bevorzugt (aber nicht notwendigerweise) befinden sich der eingangsseitige Feldeffekttransistor und der ausgangsseitige Feldeffekttransistor in einem gleichen Gehäuse oder sind auf einem gemeinsamen Chip integriert. Vorzugsweise sind die Schwellspannungen des ersten Feldeffekttransistors und des zweiten Feldeffekttransistors zumindest näherungsweise (z. B. innerhalb einer Toleranz von 5 mV oder 10 mv oder 20 mV) gleich. Optimal kann der eingangsseitige Feldeffekttransistor beispielsweise, abgesehen von einer optional verschiedenen Kanalbreite, gleich dem ausgangsseitigen Feldeffekttransistor sein, z. B. im Hinblick auf Schichtenfolge und sonstige Geometrieparameter. Allerdings können der eingangsseitige Feldeffekttransistor und der ausgangsseitige Feldeffekttransistor durchaus unterschiedliche Kanallängen und/oder Kanalbreiten haben, wobei dann aber beispielsweise das Verhältnis der K-Faktoren (z.B. von $K_1$ und $K_2$) in eine Berechnung von $V_{OUT}$ miteinfließen würde bzw. miteinzubeziehen wäre. Die Temperaturen des eingangsseitigen Feldeffekttransistors und des ausgangsseitigen Feldeffekttransistors sollten aber vorzugsweise gleich sein (z. B. durch Unterbringung der Transistoren in einem gleichen Gehäuse oder in vorzugsweise thermisch gekoppelten gleichen Gehäusen), da sich sonst die Schwellenspannungen voneinander unterscheiden. In diesem Fall wären die Berechnungen auch nicht mehr unabhängig von den Gate-Source-Spannungen der beiden Transistoren. Ferner sei darauf hingewiesen, dass der eingangsseitige Feldeffekttransistor in einem linearen Bereich betrieben wird.

Der eingangsseitige Feldeffekttransistor und der ausgangsseitige Feldeffekttransistor sind so verschaltet, dass Gate-Source-Spannungen des eingangsseitigen Feldeffekttransistors und des ausgangsseitigen Feldeffekttransistors gleich sind (was beispielsweise durch eine Verbindung der Gate-Anschlüsse der Feldeffekttransistoren und durch eine Verbindung der Source-Anschlüsse der Feldeffekttransistoren erreicht werden kann).

Die Analogrechenschaltung ist ferner ausgelegt, um die Feldeffekttransistoren so anzusteuern, dass eine Drain-Source-Spannung des eingangsseitigen Feldeffekttransistors und/oder ein Drainstrom des eingangsseitigen Feldeffekttransistors durch zumindest ein Eingangssignal (und optional auch durch ein Referenzsignal) bestimmt wird.

Indem einerseits sichergestellt wird, dass Gate-Source-Spannungen des eingangsseitigen Feldeffekttransistors und des ausgangsseitigen Feldeffekttransistors gleich sind, wird beispielsweise erreicht, dass das Verhältnis zwischen der Drain-Source-Spannung und dem Drainstrom des eingangsseitigen Feldeffekttransistors gleich dem Verhältnis zwischen der Drain-Source-Spannung und dem Drainstrom des ausgangsseitigen Feldeffekttransistors ist, oder dass die genannten Verhältnisse zumindest zueinander proportional sind. Indem dann auch noch eine Drain-Source-Spannung des eingangsseitigen Feldeffekttransistors und/oder ein Drainstrom des eingangsseitigen Feldeffekttransistors durch zumindest ein Eingangssignal (und optional auch durch ein Referenzsignal) festgelegt wird bzw. festgelegt werden, und indem ferner auch die Drain-Source-Spannung des ausgangsseitigen Feldeffekttransistors (bzw. alternativ ein Drainstrom des ausgangsseitigen Feldeffekttransistors) durch ein zweites Eingangssignal bestimmt wird, kann eine entsprechende Multiplikations-Funktionalität oder Divisions-Funktionalität erreicht werden.

So kann beispielsweise der eingangsseitige Feldeffekttransistor verwendet werden, um eine Gate-Source-Spannung sowohl des eingangsseitigen Feldeffekttransistors als auch des ausgangsseitigen Feldeffekttransistors so einzustellen bzw. so einzuregeln, dass sich ein durch das erste Eingangssignal (und optional auch durch ein Referenzsignal) bestimmtes Verhältnis zwischen der Drain-Source-Spannung und dem Drainstrom ergibt, und zwar beispielsweise sowohl bei dem eingangsseitigen Feldeffekttransistor als auch bei dem ausgangsseitigen Feldeffekttransistor (wobei die genannten Verhältnisse bei dem eingangsseitigen Feldeffekttransistor und bei dem ausgangsseitigen Feldeffekttransistor gleich oder zumindest zueinander proportional sein können). Indem dann beispielsweise der ausgangsseitige Feldeffekttransistor als einstellbarer Widerstand (eingestellt durch das erste Eingangssignal und optional auch durch das Referenzsignal) wirkt, kann dann durch das zweite Eingangssignal ein Stromfluss durch diesen durch den ausgangsseitigen Feldeffekttransistor gebildeten einstellbaren Widerstand oder eine an diesem durch den ausgangsseitigen Feldeffekttransistor gebildeten einstellbaren Widerstand anliegende Spannung eingestellt werden, und eine resultierende Spannung oder ein resultierender Strom kann verwendet werden, um ein Ausgangssignal zu erhalten. Da der einstellbare Widerstand, oder aber auch der einstellbare Leitwert (Quotient zwischen Drainstrom und Drain-Source-Spannung), der Drain-Source-Strecke des ausgangsseitigen Feldeffekttransistors typischerweise eine lineare Abhängigkeit von dem ersten Eingangssignal (und optional auch von dem Referenzsignal) aufweist, kann somit eine Multiplizierer-Funktionalität oder eine Dividierer-Funktionalität erzielt werden.

Bei einem bevorzugten Ausführungsbeispiel ist die Analogrechenschaltung ausgelegt, um die Feldeffekttransistoren so anzusteuern, dass die Drain-Source-Spannung des eingangsseitigen Feldeffekttransistors und der Drainstrom des eingangsseitigen Feldeffekttransistors durch zwei Eingangssignale (z. B. durch das erste Eingangssignal und ein Referenzsignal) bestimmt werden. Auf diese Weise kann beispielsweise sogar noch eine komplexere Funktionalität erzielt werden, da somit der effektive Widerstand der Drain-Source-Strecke des eingangsseitigen Feldeffekttransistors (und auch des ausgangsseitigen Feldeffekttransistors) durch zwei Eingangssignale eingestellt wird, wobei typischerweise eines der Eingangssignale einen linearen Einfluss auf den effektiven Widerstand der Drain-Source-Strecke hat und eines der Eingangssignale einen linearen Einfluss auf den Kehrwert des effektiven Widerstands der Drain-Source-Strecke hat (bzw., anders ausgedrückt, zum Beispiel einen umgekehrt proportionalen Einfluss auf den effektiven Widerstand hat).

Insofern wird es beispielsweise durch die Verwendung von zwei Eingangssignalen, von denen beispielsweise eines die Drain-Source-Spannung des eingangsseitigen Feldeffekttransistors einstellt bzw. bestimmt, und von denen eines den Drainstrom des eingangsseitigen Feldeffekttransistors einstellt bzw. bestimmt, ermöglicht, sowohl eine Multiplikationsfunktionalität als auch eine Divisionsfunktionalität bereitzustellen.

Bei bevorzugten Ausführungsbeispielen ist die Analogrechenschaltung so ausgelegt, dass ein Verhältnis zwischen einer Drain-Source-Spannung des eingangsseitigen Feldeffekttransistors und einem Drainstrom des eingangsseitigen Feldeffekttransistors zumindest näherungsweise (z. B. mit einer Toleranz von +/-5% oder +/-10% oder +/-20%) gleich einem Verhältnis zwischen einer Drain-Source-Spannung des ausgangsseitigen Feldeffekttransistors und einem Drainstrom des ausgangsseitigen Feldeffekttransistors ist. Alternativ kann die Analogrechenschaltung auch so ausgelegt sein, dass ein Verhältnis zwischen einer Drain-Source-Spannung des eingangsseitigen Feldeffekttransistors und einem Drainstrom des eingangsseitigen Feldeffekttransistors zumindest näherungsweise (z. B. mit einer Toleranz von +/-5% oder +/-10% oder +/-20%) proportional zu einem Verhältnis zwischen einer Drain-Source-Spannung des ausgangsseitigen Feldeffekttransistors und einem Drainstrom des ausgangsseitigen Feldeffekttransistors ist. Durch eine derartige Schaltungsauslegung kann erreicht werden, dass der einstellbare Widerstand des ausgangsseitigen Feldeffekttransistors unter Verwendung des eingangsseitigen Feldeffekttransistors eingestellt bzw. eingeregelt wird. Beispielsweise kann die Gate-Source-Spannung des eingangsseitigen Feldeffekttransistors so eingestellt bzw. eingeregelt werden, dass das Verhältnis zwischen der Drain-Source-Spannung des eingangsseitigen Feldeffekttransistors und dem Drainstrom des eingangsseitigen Feldeffekttransistors einen gewünschten, durch ein oder mehrere Eingangssignale bestimmten Wert aufweist, und dieses Verhältnis zwischen der Drain-Source-Spannung und dem Drainstrom (des eingangsseitigen Feldeffekttransistors) wird dann zu dem ausgangsseitigen Feldeffekttransistor "kopiert" bzw. "gespiegelt" (entweder unverändert oder auch skaliert) und für die Bestimmung des Ausgangssignals verwendet. Somit kann die gewünschte Multiplikationsoperation bzw. erforderlichenfalls auch eine Divisionsoperation erreicht werden.

Bei einem bevorzugten Ausführungsbeispiel ist die Analogrechenschaltung ganz allgemein ausgelegt, um ein Verhältnis zwischen einer Drain-Source-Spannung des eingangsseitigen Feldeffekttransistors und einem Drainstrom des eingangsseitigen Feldeffekttransistors in Abhängigkeit von zumindest einem Eingangssignal einzustellen.

Damit wird beispielsweise im Ergebnis auch das Verhältnis zwischen der Drain-Source-Spannung des ausgangsseitigen Feldeffekttransistors und dem Drainstrom des ausgangsseitigen Feldeffekttransistors in Abhängigkeit von dem Eingangssignal eingestellt, so dass einerseits das zur Einstellung des Verhältnisses verwendete Eingangssignal und andererseits das die Drain-Source-Spannung des ausgangsseitigen Feldeffekttransistors festlegende zweite Ausgangssignal bzw. das den Drainstrom des ausgangsseitigen Feldeffekttransistors festlegende zweite Eingangssignal als Faktoren bzw. als Dividend und Divisor einfließen.

Bei einem bevorzugten Ausführungsbeispiel ist die Analogrechenschaltung ausgelegt, um ein Verhältnis (z. B. $U_{DS}[T1\_1]/I_D [T1\_1]$) zwischen einer Drain-Source-Spannung des eingangsseitigen Feldeffekttransistors und einem Drainstrom des eingangsseitigen Feldeffekttransistors so einzustellen, dass das Verhältnis zwischen der Drain-Source-Spannung des eingangsseitigen Feldeffekttransistors und dem Drainstrom des eingangsseitigen Feldeffekttransistors (z. B. mit einer Toleranz von +/- 2% oder +/- 5% oder +/- 10% oder +/- 20%) eine lineare Abhängigkeit von einem der Eingangssignale (z. B. $V_{REF}$) aufweist. Alternativ oder zusätzlich ist die Analogrechenschaltung ausgelegt, um ein Verhältnis (z. B. $I_D[T1\_1]/U_{DS}[T1\_1]$) zwischen dem Drainstrom des eingangsseitigen Feldeffekttransistors und des Drain-Source-Spannung des eingangsseitigen Feldeffekttransistors so einzustellen, dass das Verhältnis zwischen dem Drainstrom des eingangsseitigen Feldeffekttransistors und der Drain-Source-Spannung des eingangsseitigen Feldeffekttransistors (z. B. mit einer Toleranz von +/- 2% oder +/- 5% oder +/- 10% oder +/- 20%) eine lineare Abhängigkeit von einem der Eingangssignale (z. B. $V_{INA}$) aufweist. Durch die entsprechende Ausgestaltung kann beispielsweise der (effektive) Widerstand bzw. der (effektive) Leitwert der Drain-Source-Strecke des eingangsseitigen Feldeffekttransistors basierend auf einem oder mehreren Eingangssignalen gut eingestellt werden, und dieses Verhältnis wird dann unmittelbar oder skaliert zu dem ausgangsseitigen Feldeffekttransistor übernommen und bei der Bestimmung des Ausgangssignals ausgenutzt. Insofern kann durch Sicherstellung der oben genannten entsprechenden linearen Abhängigkeit die gewünschte Multiplikations-Funktionalität bzw. Divisions-Funktionalität (oder sogar eine kombinierte Multiplikations- und Divisions-Funktionalität) gut erreicht werden.

Bei einem bevorzugten Ausführungsbeispiel ist die Analogrechenschaltung ausgelegt, um den eingangsseitigen Feldeffekttransistor so anzusteuern (beispielsweise durch eine Regelung der Gate-Source-Spannung), dass eine Drain-Source-Spannung des eingangsseitigen Feldeffekttransistors eine lineare Abhängigkeit von einem der Eingangssignale (z. B. $V_{REF}$) aufweist (also beispielsweise gleich der entsprechenden Eingangsspannung ist, oder proportional zu einer entsprechenden Eingangsspannung ist) oder konstant ist. Alternativ oder zusätzlich ist die Analogrechenschaltung ferner ausgelegt, um den eingangsseitigen Feldeffekttransistor so anzusteuern (beispielsweise durch eine Regelung der Gate-Source-Spannung), dass ein Drainstrom des eingangsseitigen Feldeffekttransistors eine lineare Abhängigkeit von einem der Eingangssignale (z. B. $V_{INA}$) aufweist oder konstant ist. Bei den entsprechenden Eingangssignalen kann es sich beispielsweise um Eingangsspannungen oder um Eingangsströme handeln. Im Übrigen sei darauf hingewiesen, dass die entsprechende lineare Abhängigkeit beispielsweise unter der Voraussetzung gegeben sein kann, dass eine jeweils andere Eingangsgröße oder eine Referenzgröße konstant ist.

Durch eine entsprechende Schaltungsauslegung kann wiederum das Verhältnis zwischen der Drain-Source-Spannung und dem Drainstrom des eingangsseitigen Feldeffekttransistors, und damit das Verhältnis zwischen der Drain-Source-Spannung und dem Drainstrom des ausgangsseitigen Feldeffekttransistors in Abhängigkeit von einem oder mehreren Eingangssignalen so festgelegt werden, dass die gewünschte Multiplikationsfunktionalität und/oder die gewünschte Divisionsfunktionalität erzielt werden kann.

Bei einem bevorzugten Ausführungsbeispiel ist die Analogrechenschaltung so ausgelegt, dass eine lineare Abhängigkeit zwischen einem Drainstrom des ausgangsseitigen Feldeffekttransistors und dem Ausgangssignal besteht. Beispielsweise kann die Ausgangsspannung entsprechend der folgenden Formel berechnet werden: $V_{OUT}=V_{INB}+R_2 \cdot I_D[T1\_2]$. Eine derartige Ableitung des Ausgangssignals ist einerseits mit geringem Schaltungsaufwand möglich und verursacht ferner typischerweise keine signifikante Verfälschung des Ausgangssignals. Im Übrigen hat sich gezeigt, dass auch mit einer entsprechenden einfachen Ableitung des Ausgangssignals von dem Drainstrom des ausgangsseitigen Feldeffekttransistors ein gutes Ergebnis der Multiplikationsoperation und/oder der Divisionsoperation erzielt werden kann.

Bei einem bevorzugten Ausführungsbeispiel ist die Analogrechenschaltung ausgelegt, um den ausgangsseitigen Feldeffekttransistor so anzusteuern, dass ein (zumindest näherungsweise, beispielsweise mit einer Toleranz von +/-5%, oder +/-10%, oder +/-20%, linearer) Zusammenhang zwischen einem Drainstrom des ausgangsseitigen Feldeffekttransistors und einer Drain-Source-Spannung des ausgangsseitigen Feldeffekttransistors durch zumindest ein Eingangssignal ($V_{INA}$, $V_{REF}$) bestimmt wird. Es hat sich gezeigt, dass durch das entsprechende Konzept in effizienter Weise eine Multiplikationsoperation und/oder eine Divisionsoperation durchgeführt werden kann, da das durch das Eingangssignal (z. B. $V_{INA}$) variierbare Verhältnis zwischen dem Drainstrom des ausgangsseitigen Feldeffekttransistors und der Drain-Source-Spannung des ausgangsseitigen Feldeffekttransistors (bzw. das durch das Eingangssignal variiebare Verhältnis zwischen der Drain-Source-Spannung des ausgangsseitigen Feldeffekttransistors und dem Drainstrom des ausgangsseitigen Feldeffekttransistors) unter Verwendung einer Einstellung der Drain-Source-Spannung des ausgangsseitigen Feldeffekttransistors oder des Drainstroms des ausgangsseitigen Feldeffekttransistors durch ein zweites Eingangssignal für eine effiziente Bestimmung des Ausgangssignals verwendet werden kann. Im Ergebnis wird nämlich beispielsweise der effektive Widerstand der Drain-Source-Strecke des ausgangsseitigen Feldeffekttransistors mit dem durch die Drain-Source-Strecke des ausgangsseitigen Feldeffekttransistors fließenden Strom multipliziert, um eine Spannung zu erhalten, die in das Ausgangssignal einfließt, oder es wird beispielsweise der effektive Leitwert der Drain-Source-Strecke des ausgangsseitigen Feldeffekttransistors mit der durch ein zweites Eingangssignal bestimmten Drain-Source-Spannung des ausgangsseitigen Feldeffekttransistors multipliziert, um einen Drainstrom des ausgangsseitigen Feldeffekttransistors zu erhalten, der schließlich in das Ausgangssignal einfließt (bzw. auf der Basis dessen das Ausgangssignal bestimmt wird).

Insofern gibt es hier zur Bestimmung des Ausgangssignals eine Multiplikation (bzw. alternativ auch eine Division) auf Basis des durch zumindest ein Eingangssignal bestimmten effektiven Widerstands oder effektiven Leitwerts des ausgangsseitigen Transistors und einer durch das zweite Eingangssignal bestimmten Größe (z. B. einer Drain-Source-Spannung des ausgangsseitigen Feldeffekttransistors bzw. eines Drainstroms des ausgangsseitigen Feldeffekttransistors), wodurch sich die Multiplikations-Wirkung bzw. Divisions-Wirkung ergibt.

Bei dem bevorzugten Ausführungsbeispiel ist die Analogrechenschaltung ausgelegt, um den ausgangsseitigen Feldeffekttransistor so anzusteuern (beispielsweise durch Einstellen bzw. Einregeln der Gate-Source-Spannung), dass ein Verhältnis zwischen der Drain-Source-Spannung des ausgangsseitigen Feldeffekttransistors (z. B. T1_2) und dem Drainstrom des ausgangsseitigen Feldeffekttransistors zumindest näherungsweise (z. B. mit einer Toleranz von +/- 5% oder +/- 10% oder +/- 20%) eine lineare Abhängigkeit von einem der Eingangssignale (z. B. $V_{REF}$) aufweist. Alternativ oder zusätzlich ist die Analogrechenschaltung ausgelegt, um den ausgangsseitigen Feldeffekttransistor so anzusteuern, dass ein Verhältnis zwischen dem Drainstrom des ausgangsseitigen Feldeffekttransistors (z. B. T1_2) und der Drain-Source-Spannung des ausgangsseitigen Feldeffekttransistors (z. B. T1_2) zumindest näherungsweise (z. B. mit einer Toleranz von +/- 5% oder +/- 10% oder +/- 20%) eine lineare Abhängigkeit von einem der Eingangssignale (z. B. $V_{INA}$) aufweist. Dadurch wird erreicht, dass das Verhältnis zwischen der Drain-Source-Spannung des ausgangsseitigen Feldeffekttransistors und dem Drainstrom des ausgangsseitigen Feldeffekttransistors, oder das (dazu inverse) Verhältnis zwischen dem Drainstrom des ausgangsseitigen Feldeffekttransistors und der Drain-Source-Spannung des ausgangsseitigen Feldeffekttransistors, das beispielsweise als multiplikativer Faktor oder als Divisor in die Bestimmung des Ausgangssignals einfließt (beispielsweise indem ein durch das zweite Eingangssignal bestimmtes Signal dadurch multiplikativ skaliert wird, um das Ausgangssignal zu erhalten, oder indem ein durch das Ausgangssignal bestimmtes Signal dadurch im Sinne einer Division skaliert wird, um das Ausgangssignal zu erhalten) in effizienter Weise bestimmt wird. Indem das genannte Verhältnis zwischen der Drain-Source-Spannung des ausgangsseitigen Feldeffekttransistors und dem Drainstrom des ausgangsseitigen Feldeffekttransistors bzw. das genannte Verhältnis zwischen dem Drainstrom des ausgangsseitigen Feldeffekttransistors und der Drain-Source-Spannung des ausgangsseitigen Feldeffekttransistors eine zumindest näherungsweise lineare Abhängigkeit von einer oder sogar mehreren Ausgangsgrößen aufweist, ist also der multiplikative Faktor oder der Divisor, der bei der Bestimmung des Ausgangssignals mitwirkt, und der auf eine durch das zweite Eingangssignal bestimmte elektrische Größe angewendet wird, wohl bestimmt und ermöglich somit eine Multiplikationsoperation bzw. Divisionsoperation mit guter Genauigkeit.

Bei einem bevorzugten Ausführungsbeispiel weist die Analogrechenschaltung einen eingangsseitigen Feldeffekttransistor auf. Die Analogrechenschaltung weist ferner einen ersten Operationsverstärker auf, der ausgelegt ist, um eine Gate-Source-Spannung des eingangsseitigen Feldeffekttransistors einzustellen, um die Drain-Source-Spannung des eingangsseitigen Feldeffekttransistors auf einen vorgegebenen Wert (z. B. $V_{REF}$ oder $V_{REF} \cdot R_4/(R_3+R_4)$) zu regeln. Dies kann beispielsweise derart erfolgen, dass der eingangsseitigen Feldeffekttransistor in einem linearen Bereich betrieben wird. Der lineare Betrieb kann beispielsweise sichergestellt werden, indem dafür Sorge getragen wird, dass die Drain-Source-Spannung ausreichend klein ist oder einen vorgegebenen Wert nicht übersteigt. Durch eine entsprechende Vorgehensweise kann erreicht werden, dass der eingangsseitigen Feldeffekttransistor an einem geeigneten Arbeitspunkt betrieben wird, wobei durch Variation der Drain-Source-Spannung des eingangsseitigen Feldeffekttransistors (beispielsweise in Abhängigkeit von dem Referenzsignal $V_{REF}$ bzw. einem an die Stelle des Referenzsignals

$V_{REF}$ tretenden variablen weiteren Eingangssignals) ein weiterer Multiplikations- bzw. Divisionseffekt erzielt werden kann, der beispielsweise von der eingestellten Drain-Source-Spannung des eingangsseitigen Feldeffekttransistors abhängig ist. Durch eine entsprechende Operationsverstärker-basierte Regelung der Gate-Source-Spannung des eingangsseitigen Feldeffekttransistors kann im Übrigen ein gewünschter Betriebszustand des eingangsseitigen Feldeffekttransistors einerseits mit guter Genauigkeit und andererseits mit vergleichsweise geringem Schaltungsaufwand erzielt werden, wobei die Gate-Source-Spannung des eingangsseitigen Feldeffekttransistors beispielsweise auch als Gate-Source-Spannung des ausgangsseitigen Feldeffekttransistors übernommen werden kann. Somit kann beispielsweise für beide Feldeffekttransistoren gemeinsam ein geeigneter Arbeitspunkt festgelegt werden.

Bei einem bevorzugten Ausführungsbeispiel ist der Operationsverstärker ausgelegt, um die Drain-Source-Spannung des eingangsseitigen Feldeffekttransistors auf einen vorgegebenen Wert zu regeln, wobei ein Drainstrom des eingangsseitigen Feldeffekttransistors durch ein Eingangssignal (z. B. $V_{INA}$) bestimmt wird. Indem somit sowohl die Drain-Source-Spannung des eingangsseitigen Feldeffekttransistors als auch der Drainstrom des eingangsseitigen Feldeffekttransistors festgelegt werden, kann im Ergebnis das Verhältnis zwischen der Drain-Source-Spannung des eingangsseitigen Feldeffekttransistors und dem Drainstrom des eingangsseitigen Feldeffekttransistors durch zumindest ein variables Eingangssignal (beispielsweise in Verbindung mit einem konstanten Referenzsignal) oder sogar durch zwei variable Eingangssignale (von denen beispielsweise eines die Drain-Source-Spannung des eingangsseitigen Feldeffekttransistors festlegt, und von denen ein anderes den Drainstrom des eingangsseitigen Feldeffekttransistors festlegt) festgelegt werden. Der Operationsverstärker kann beispielsweise die Gate-Source-Spannung des eingangsseitigen Feldeffekttransistors (und damit bevorzugt auch unmittelbar die Gate-Source-Spannung des ausgangsseitigen Feldeffekttransistors) so einstellen, bzw. so einregeln, dass sich das gewünschte Verhältnis zwischen Drain-Source-Spannung und Drainstrom ergibt. Somit ist letztlich auch das Verhältnis zwischen der Drain-Source-Spannung des ausgangsseitigen Feldeffekttransistors und dem Drainstrom des ausgangsseitigen Feldeffekttransistors durch ein oder mehrere Eingangssignale vorgebbar, so dass auch das Ausgangssignal durch Einprägen einer elektrischen Größe (z. B. Strom oder Spannung) in die Drain-Source-Strecke des ausgangsseitigen Feldeffekttransistors basierend auf der sich ergebenden Antwortgröße (Spannung oder Strom) erhalten werden kann.

Bei einem bevorzugten Ausführungsbeispiel weist die Analogrechenschaltung einen zweiten Operationsverstärker auf, der ausgelegt ist, um eine Drain-Source-Spannung des ausgangsseitigen Feldeffekttransistors auf einen Spannungswert zu regeln, der durch das zweite Eingangssignal bestimmt wird. Dementsprechend kann beispielsweise eine elektrische Größe, in diesem Fall die Drain-Source-Spannung des ausgangsseitigen Feldeffekttransistors, festgelegt werden, und die Antwortgröße (z. B. der Drainstrom), die sich in Anbetracht des eingestellten Verhältnisses zwischen Drain-Source-Spannung und Drainstrom ergibt, kann für die Bestimmung des Ausgangssignals verwendet werden. Der Einsatz einer Operationsverstärkerschaltung zur Regelung der Drain-Spannung des ausgangsseitigen Feldeffekttransistors auf einen durch das zweite Eingangssignal vorgegebenen Wert hat sich hierbei als besonders vorteilhaft erwiesen, da der Stromfluss in den Eingang des Operationsverstärkers typischerweise vernachlässigbar ist, wodurch der sich ergebende Drainstrom des ausgangsseitigen Feldeffekttransistors gut für die Bestimmung des Ausgangssignals verwendbar ist.

Bei einem bevorzugten Ausführungsbeispiel weist die Analogrechenschaltung einen eingangsseitigen Feldeffekttransistor, einen ersten Operationsverstärker und einen zweiten Operationsverstärker auf (beispielsweise zusätzlich zu dem ausgangsseitigen Feldeffekttransistor, der oben bereits genannt wurde). Ein erster Eingang des ersten Operationsverstärkers ist beispielsweise mit einem ersten Signaleingang für ein erstes Eingangssignal (z. B. über einen Widerstand) und mit einem Drain-Anschluss des eingangsseitigen Feldeffekttransistors (z.B. niederohmig) gekoppelt. Ein zweiter Eingang des ersten Operationsverstärkers ist mit einem vorgegebenen Referenzsignal oder mit einem weiteren Signaleingang (für ein weiteres Eingangssignal) gekoppelt. Ein Ausgang des ersten Operationsverstärkers ist mit einem Gate-Anschluss des eingangsseitigen Feldeffekttransistors und mit einem Gate-Anschluss des ausgangsseitigen Feldeffekttransistors gekoppelt. Source-Anschlüsse des eingangsseitigen Feldeffekttransistors und des ausgangsseitigen Feldeffekttransistors sind miteinander gekoppelt und beispielsweise mit einem Bezugspotential verbunden. Ein erster Eingang des zweiten Operationsverstärkers ist mit einem zweiten Signaleingang (für ein zweites Eingangssignal) gekoppelt. Ein zweiter Eingang des zweiten Operationsverstärkers ist mit einem Drain-Anschluss des ausgangsseitigen Feldeffekttransistors gekoppelt. Die Analogrechenschaltung weist ferner einen Widerstand auf, der zwischen den Drain-Anschluss des ausgangsseitigen Feldeffekttransistors und einem Ausgang des zweiten Operationsverstärkers geschaltet ist. Der Ausgang des zweiten Operationsverstärkers ist mit einem Signalausgang gekoppelt.

Die entsprechende Verschaltung ermöglicht in besonders effizienter Weise die Multiplikation zweier Eingangssignale oder eine Division zweier Eingangssignale, oder sogar eine kombinierte Operation, bei der zwei Eingangssignale miteinander multipliziert und durch ein drittes Eingangssignal geteilt werden. Beispielsweise werden hierbei nur zwei Feldeffekttransistoren und zwei Operationsverstärker benötigt, wodurch einerseits der Realisierungsaufwand gering gehalten werden kann, und wodurch andererseits auch der Stromverbrauch deutlich geringer sein kann als bei alternativen Konzepten. Im Übrigen hat sich gezeigt, dass das Ausgangssignal für viele Anwendungen eine ausreichende Präzision aufweist. Insofern stellt das genannte Konzept einen guten Kompromiss zwischen dem Implementierungsaufwand, Stromverbrauch und Präzision dar.

Im Übrigen sei darauf hingewiesen, dass alle oben beschriebenen Ausführungsbeispiele optional um die im Folgenden noch beschriebenen Merkmale, Funktionalitäten und Details ergänzt werden können, und zwar sowohl einzeln als auch in Kombination.

Figurenkurzbeschreibung

Ausführungsbeispiele gemäß der vorliegenden Erfindung werden nachfolgend Bezug nehmend auf die beiliegenden Figuren näher erläutert.

Es zeigen:

Fig. 1 ein Blockschaltbild einer erfindungsgemäßen Analogrechenschaltung gemäß einem Ausführungsbeispiel der vorliegenden Erfindung;

Fig. 2 ein Schaltbild einer Schaltung einer Gilbertzelle;

Fig. 3 ein Schaltbild eines alternativen Lösungswegs über eine Logarithmusfunktion;

Fig. 4 ein Schaltbild einer Standardschaltung mit Operationsverstärker zur Multiplizierung von Signalen;

Fig. 5 ein Schaltbild einer Grundschaltung eines Multiplizierers mit gesteuerten MOS-Transistoren, gemäß einem Ausführungsbeispiel der vorliegenden Erfindung;

Fig. 6 ein Schaltbild einer Variante des vorgeschlagenen Multiplizierers mit Spannungsteilern.

Detaillierte Beschreibung der Ausführungsbeispiele

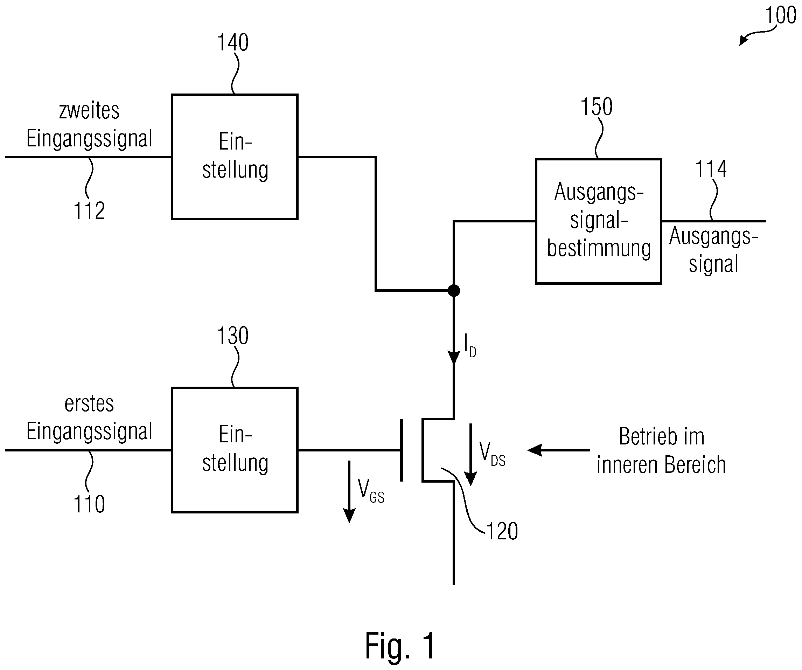

1. Ausführungsbeispiele gemäß Fig. 1

Fig. 1 zeigt ein Blockschaltbild einer Analogrechenschaltung (z. B. einer Multipliziererschaltung und/oder Dividiererschaltung) gemäß einem Ausführungsbeispiel der vorliegenden Erfindung.

Die Schaltungsanordnung gemäß der Fig. 1 ist in ihrer Gesamtheit mit 100 bezeichnet.

Die Analogrechenschaltung ist ausgelegt, um ein erstes Eingangssignal 110 und ein zweites Eingangssignal 112 zu empfangen und basierend darauf ein Ausgangssignal 114 bereitzustellen. Das erste Eingangssignal 110 kann beispielsweise durch eine Spannung, die eine erste Eingangsgröße darstellt, repräsentiert werden. Alternativ kann das erste Eingangssignal auch durch einen Strom, der die erste Eingangsgröße darstellt, repräsentiert werden. In ähnlicher Weise kann das zweite Eingangssignal durch eine Spannung, die eine zweite Eingangsgröße darstellt, repräsentiert werden, oder auch durch einen Strom, der die zweite Eingangsgröße darstellt. Das Ausgangssignal 114 kann beispielsweise eine Spannung sein, die eine Ausgangsgröße darstellt, oder alternativ auch ein Strom, der die Ausgangsgröße darstellt.

Es sei darauf hingewiesen, dass das erste Eingangssignal 110, das zweite Eingangssignal 112 und das Ausgangssignal 114 typischerweise Analogsignale (also beispielsweise zeitkontinuierliche und wertkontinuierliche Signale) sind.

Die Analogrechenschaltung umfasst einen ausgangsseitigen Feldeffekttransistor 120, der in einem linearen Bereich betrieben wird. Wie dem Fachmann bekannt ist, liegt in dem linearen Bereich die Gate-Source-Spannung $U_{GS}$ über der Schwellenspannung $U_{TH}$, so dass ein durchgehender Kanal zwischen Drain und Source entsteht. Ferner wird der Bereich in der Kennlinie durch die Grenzspannung $U_{DS,sat} = U_{GS}-U_{TH}$ begrenzt. Es ist also in dem linearen Bereich die Drain-Source-Spannung vorzugsweise kleiner als die Differenz zwischen der Gate-Source-Spannung $U_{GS}$ und der Schwellenspannung $U_{TH}$, was beispielsweise durch eine geeignete Einstellung bzw. Begrenzung der Drain-Source-Spannung erreicht werden kann. Im Übrigen sei darauf hingewiesen, dass der lineare Bereich auch "Triodenbereich", "ohmscher Bereich" oder "aktiver Bereich" genannt wird und dem Fachmann wohlbekannt ist (engl.: "triode region" or "ohmic region").

Die Analogrechenschaltung umfasst eine Einstellung bzw. Einstellschaltung 130, die ausgelegt ist, um die Gate-Source-Spannung $V_{GS}$ (auch als $U_{GS}$ bezeichnet) des ausgangsseitigen Feldeffekttransistors in Abhängigkeit von zumindest einem Eingangssignal, also zum Beispiel in Abhängigkeit von dem ersten Eingangssignal 110, einzustellen. Damit wird beispielsweise der effektive Widerstand der Drain-Source-Strecke des ausgangsseitigen Feldeffekttransistors 120 eingestellt, also beispielsweise das Verhältnis zwischen der Drain-Source-Spannung $V_{DS}$ und dem Drainstrom $I_D$ des ausgangsseitigen Feldeffekttransistors 120.

Die Analogrechenschaltung 100 umfasst ferner eine Einstellung bzw. Einstellschaltung 140, die ausgelegt ist, um eine Drain-Source-Spannung des ausgangsseitigen Feldeffekttransistors (oder, alternativ, einen Drainstrom des ausgangsseitigen Feldeffekttransistors) in Abhängigkeit von einem zweiten Eingangssignal, beispielsweise dem zweiten Eingangssignal 112, einzustellen, so dass also die Drain-Source-Spannung des ausgangsseitigen Feldeffekttransistors 120 (oder, alternativ, ein Drainstrom des ausgangsseitigen Feldeffekttransistors) durch das zweite Eingangssignal bestimmt wird.

Ferner umfasst die Analogrechenschaltung eine Ausgangssignalbestimmung bzw. eine Ausgangssignalbestimmungsschaltung 150, die ausgelegt ist, um das Ausgangssignal in Abhängigkeit von einem Stromfluss durch den ausgangsseitigen Feldeffekttransistor 120 (beispielsweise wenn die Drain-Source-Spannung des ausgangsseitigen Feldeffekttransistors 120 eingeprägt wird) oder in Abhängigkeit von einer Drain-Source-Spannung des ausgangsseitigen Feldeffekttransistors 120 (beispielsweise wenn der Drainstrom des ausgangsseitigen Feldeffekttransistors eingeprägt wird) zu erhalten. In anderen Worten, die Analogrechenschaltung ist ausgelegt, um das Ausgangssignal 114 in Abhängigkeit von einem Stromfluss durch den ausgangsseitigen Feldeffekttransistor 120 zu erhalten, wobei die Drain-Source-Spannung $V_{DS}$ des ausgangsseitigen Feldeffekttransistors durch das zweite Eingangssignal 112 bestimmt wird, oder die Analogrechenschaltung ist ausgelegt, um das Ausgangssignal 114 in Abhängigkeit von einer Drain-Source-Spannung des ausgangsseitigen Feldeffekttransistors zu erhalten, wobei ein Drainstrom des ausgangsseitigen Feldeffekttransistors 120 durch das zweite Eingangssignal 112 bestimmt wird.

Zusammenfassend kann man hier sagen, dass einerseits der Widerstand der Drain-Source-Strecke des ausgangsseitigen Feldeffekttransistors 120 durch das erste Eingangssignal eingestellt wird, und dass andererseits dieser Widerstand (im Sinne eines Verhältnisses zwischen der Drain-Source-Spannung $V_{DS}$ des ausgangsseitigen Feldeffekttransistors und dem Drainstrom $I_D$ des ausgangsseitigen Feldeffekttransistors) dann als variabler multiplikativer Faktor oder als variabler Divisor bei der Bestimmung des Ausgangssignals 114 einfließt. Der Widerstand der Drain-Source-Strecke wird nämlich verwendet, um basierend auf einer entsprechenden Drain-Source-Spannung, die durch das zweite Eingangssignal bestimmt wird, einen Drainstrom $I_D$ zu erhalten, auf der Basis dessen das Ausgangssignal 114 erzeugt wird. Alternativ wird der genannte, durch das erste Eingangssignal 110 eingestellte bzw. einstellbare Widerstand der Drain-Source-Strecke dazu verwendet, um basierend auf einem Drainstrom, der durch das zweite Eingangssignal 112 bestimmt wird, eine Drain-Source-Spannung zu erhalten, auf der Basis derer das Ausgangssignal 114 bestimmt wird. Es wird hier also die Eigenschaft des ausgangsseitigen Feldeffekttransistors 120 ausgenutzt, so dass dieser bei dem Betrieb in dem linearen Bereich (zumindest bei ausreichend kleiner Drain-Source-Spannung) eine Charakteristik aufweist, bei der Drainstrom und Drain-Source-Spannung zumindest näherungsweise proportional zueinander sind. Indem also dieser Proportionalitätsfaktor (effektiver Widerstand der Drain-Source-Strecke) basierend auf dem ersten Eingangssignal 110 eingestellt wird (beispielsweise derart, dass der Widerstand proportional oder umgekehrt proportional zu dem ersten Eingangssignal ist) kann die entsprechende Multiplikations-Funktionalität oder Divisions-Funktionalität erzielt werden.

Die hier beschriebene Schaltungsanordnung ist schaltungstechnisch effizient und stromsparend realisierbar und ermöglicht es auch, einen Übergang zu einer digitalen Signalverarbeitung zu vermeiden. Im Übrigen wurde erkannt, dass die Präzision der Schaltungsanordnung in vielen Anwendungen ausreichend ist.

Zusammenfassend ist somit festzuhalten, dass das Erfindungskonzept einen sehr guten Kompromiss im Hinblick auf Funktionalität, Realisierungsaufwand und Stromverbrauch liefert.

Ferner sei darauf hingewiesen, dass die Schaltungsanordnung gemäß der Fig. 1 optional um alle Merkmale, Funktionalitäten und Details ergänzt werden kann, die hierin beschrieben sind, und zwar sowohl einzeln als auch in Kombination.

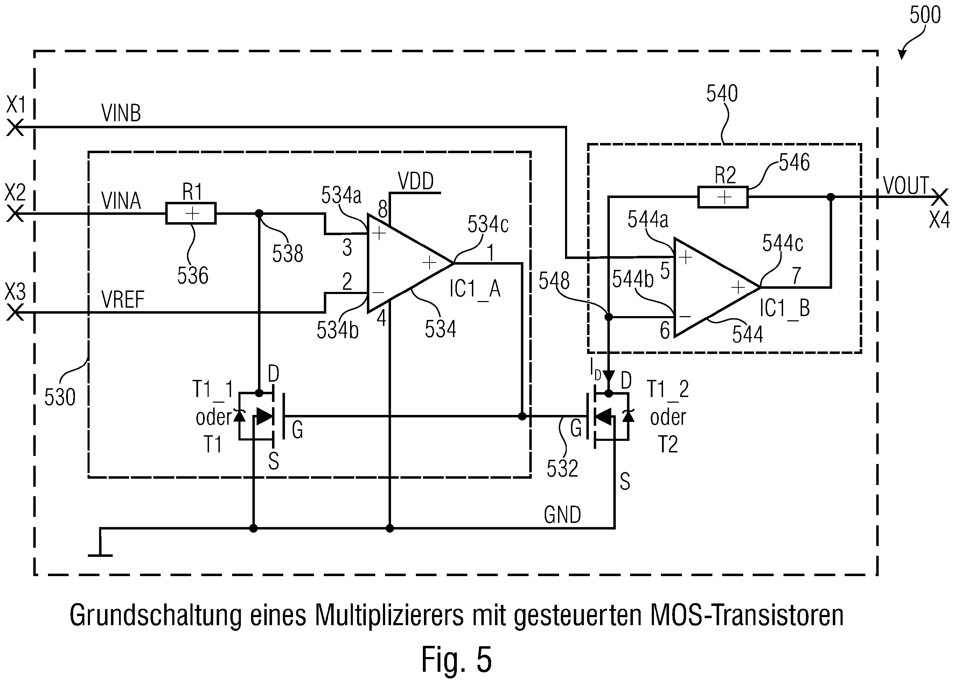

2. Ausführungsbeispiel gemäß Fig. 5

Fig. 5 zeigt ein Schaltbild einer Grundschaltung eines Multiplizierers mit gesteuerten MOS-Transistoren, gemäß einem Ausführungsbeispiel der vorliegenden Erfindung. Die Schaltungsanordnung gemäß der Fig. 5 ist in der Gesamtheit mit 500 bezeichnet. Die Schaltungsanordnung gemäß der Fig. 5 ist beispielsweise ausgelegt, um ein erstes Eingangssignal VINA (hierin manchmal auch mit $V_{INA}$ bezeichnet), ein zweites Eingangssignal VINB (hierin manchmal auch mit $V_{INB}$ bezeichnet) und ein Referenzsignal VREF (hierin manchmal auch mit $V_{REF}$ bezeichnet) zu erhalten. Die Schaltungsanordnung 500 liefert ferner ein Ausgangssignal VOUT (hierin manchmal auch mit $V_{OUT}$ bezeichnet).

Diesbezüglich sei darauf hingewiesen, dass anstelle des Referenzsignals $V_{REF}$ auch ein weiteres Eingangssignal (z. B. $V_{INC}$) verwendet werden kann.

Allgemein gesprochen umfasst die Schaltungsanordnung 500 eine Einstellschaltung bzw. Regelschaltung (bzw. noch allgemeiner: einen Schaltungsblock) 530, der eine Gate-Source-Spannung eines ausgangsseitigen Feldeffekttransistors T1_2 (oder auch T2) in Abhängigkeit von dem ersten Eingangssignal $V_{INA}$ und auch in Abhängigkeit von dem Referenzsignal $V_{REF}$ einstellt. Die Schaltungsanordnung 500 umfasst ferner eine Einstellschaltung oder eine Regelschaltung (oder allgemeiner gesprochen, einen Schaltungsblock) 540, der einerseits eine Drain-Source-Spannung des ausgangsseitigen Feldeffekttransistors T1_2 (oder T2) in Abhängigkeit von dem zweiten Eingangssignal $V_{INB}$ einstellt, und der andererseits das Ausgangssignal $V_{OUT}$ in Abhängigkeit von dem Drainstrom $I_D$ des ausgangsseitigen Feldeffekttransistors T1_2 (oder T2) bereitstellt.

Diesbezüglich sei angemerkt, dass der Schaltungsblock 530 beispielsweise dem Schaltungsblock 130 gemäß Fig. 1 entsprechen kann, und dass beispielsweise der Schaltungsblock 540 die Aufgaben der Schaltungsblöcke 140, 150 gemäß Fig. 1 übernehmen kann.

Es sei allerdings darauf hingewiesen, dass die Aufteilung der Funktionalitäten auf bestimmte Schaltungsblöcke hier nicht essenziell ist.

Im Folgenden wird auf die Funktionalität der einzelnen Schaltungsblöcke und auch auf deren Struktur näher eingegangen.

Der Schaltungsblock 530 empfängt beispielsweise das erste Eingangssignal $V_{INA}$ und das Referenzsignal $V_{REF}$ und liefert, basierend darauf, ein Gate-Signal 532 für den ausgangsseitigen Feldeffekttransistor T1_2 (oder T2).

Der Schaltungsblock 530 umfasst einen eingangsseitigen Feldeffekttransistor T1_1 (auch mit T1 bezeichnet). Ferner umfasst der eingangsseitige Schaltungsblock einen Operationsverstärker 534, dessen Ausgang mit den Gate-Anschlüssen des eingangsseitigen Feldeffekttransistors T1_1 (oder T1) und des ausgangsseitigen Feldeffekttransistors T1_2 (oder T2) gekoppelt ist.

Beispielsweise sind der eingangsseitige Feldeffekttransistor T1_1 und der ausgangsseitige Feldeffekttransistor T1_2 ähnlich oder sogar identisch aufgebaut und beispielsweise derart angeordnet, dass sie sich zumindest näherungsweise auf der gleichen Temperatur befinden. Beispielsweise sind der eingangsseitige Feldeffekttransistor T1_1 und der ausgangsseitige Feldeffekttransistor T1_2 in einem gemeinsamen Gehäuse untergebracht, oder sogar auf einem gemeinsamen Halbleitersubstrat angeordnet. Im Übrigen weisen der eingangsseitige Feldeffekttransistor T1_1 und der ausgangsseitige Feldeffekttransistor T1_2 bevorzugt eine gleichartige Schichtenfolge auf (beispielsweise im Hinblick auf Dotierungsverläufe, Gate-Isolator und Gate-Material), so dass der eingangsseitige Feldeffekttransistor T1_1 und der ausgangsseitige Feldeffekttransistor T1_2 bevorzugt gleiche Schwellenspannungen aufweisen. Kanallängen und Kanalbreiten der beiden Feldeffekttransistoren T1_1 und T1_2 können sich optional unterscheiden, es wird aber bevorzugt, Transistoren mit zumindest gleicher Gate-Länge zu verwenden. Es sei darauf hingewiesen, dass es sich bei den Transistoren T1_1 und T1_2 auch um separate (beispielsweise diskrete) Transistoren handeln kann, wobei bevorzugt wird, dass die beiden Transistoren sich zumindest in einer gleichen Umgebung befinden, so dass sich deren Temperaturen nicht wesentlich unterscheiden. Eine thermische Koppelung ist aber wünschenswert.

Im Übrigen wird durch eine geeignete Wahl der Ansteuerung (beispielsweise durch eine geeignete Wahl des Referenzsignals $V_{REF}$ und auch des zweiten Eingangssignals $V_{INB}$) sichergestellt, dass sowohl der eingangsseitige Feldeffekttransistor T1_1 als auch der ausgangsseitige Feldeffekttransistor T1_2 in einem linearen Bereich betrieben werden, in dem ein Drainstrom zumindest näherungsweise proportional zu einer Drain-Source-Spannung ist.

Im Hinblick auf die Anordnung der Feldeffekttransistoren sei darauf hingewiesen, dass beispielsweise die Gate-Anschlüsse der Feldeffekttransistoren T1_1, T1_2 miteinander verbunden sind, und dass auch die Source-Anschlüsse der Feldeffekttransistoren T1_1, T1_2 miteinander verbunden sind. Dadurch wird erreicht, dass die Gate-Source-Spannungen des eingangsseitigen Feldeffekttransistors T1_1 und des ausgangsseitigen Feldeffekttransistors T1_2 gleich sind. Im Übrigen sind die Gate-Anschlüsse der beiden Feldeffekttransistoren beispielsweise mit dem Ausgang des ersten Operationsverstärkers 534 verbunden, wobei bei dem Ausführungsbeispiel gemäß der Fig. 5 sogar eine direkte Verbindung gegeben ist.

Ein invertierender Eingang 534b des ersten Operationsverstärkers 534 ist beispielsweise mit dem Referenzsignal $V_{REF}$ gekoppelt. Ein nicht-invertierender Eingang 534a des ersten Operationsverstärkers 534 ist beispielsweise mit dem Drain-Anschluss des eingangsseitigen Feldeffekttransistors T1_1 gekoppelt, wobei die Kopplung beispielsweise niederohmig sein kann, so dass kein wesentlicher Spannungsabfall zwischen dem Drain-Anschluss D des eingangsseitigen Feldeffekttransistors T1_1 (oder T1) und dem nicht-invertierenden Eingang 534a des ersten Operationsverstärkers 534b besteht. Damit kann beispielsweise der erste Operationsverstärker 543 die Gate-Source-Spannung des eingangsseitigen Feldeffekttransistors T1_1 so regeln, dass das Potenzial an einem Drain-Anschluss des eingangsseitigen Feldeffekttransistors T1_1 - von einer Regelungenauigkeit abgesehen - gleich einem Potenzial des Referenzsignals $V_{REF}$ ist. In anderen Worten, der erste Operationsverstärker 534 regelt beispielsweise die Gate-Source-Spannung des eingangsseitigen Feldeffekttransistors T1_1 so, dass die Drain-Source-Spannung des eingangsseitigen Feldeffekttransistors T1_1 durch das Referenzsignal $V_{REF}$ festgelegt wird.

Im Übrigen weist der Schaltungsblock 530 einen ersten Widerstand 536 auf, der beispielsweise zwischen dem Eingang für das erste Eingangssignal $V_{INA}$ und einem Schaltungsknoten 538 geschaltet ist, an dem der Drain-Anschluss des eingangsseitigen Feldeffekttransistors T1_1 mit dem nicht-invertierenden Eingang 534a des ersten Operationsverstärkers 534 gekoppelt ist. Insofern bestimmt das Eingangssignal $V_{INA}$ (oder, genauer gesagt, eine Spannungsdifferenz zwischen dem Eingangssignal $V_{INA}$ und dem Referenzsignal $V_{REF}$) den Strom durch die Drain-Source-Strecke des eingangsseitigen Feldeffekttransistors T1_1, wobei der Widerstand 536 beispielsweise den Zusammenhang zwischen der genannten Spannungsdifferenz und dem Drainstrom $I_D$ des eingangsseitigen Feldeffekttransistors T1_1 bestimmt, und wobei beispielsweise davon ausgegangen werden kann, dass ein Eingangsstrom in den nicht-invertierten Eingang 534a des ersten Operationsverstärkers 534 vernachlässigbar ist.

Somit ist insgesamt festzuhalten, dass der erste Operationsverstärker 534 die Gate-Source-Spannung des eingangsseitigen Feldeffekttransistors T1_1 so regelt, dass die Drain-Source-Spannung des eingangsseitigen Feldeffekttransistors T1_1 bei dem durch das Eingangssignal $V_{INA}$ (beispielsweise in Verbindung mit dem Referenzsignal $V_{REF}$) festgelegten Drainstrom des eingangsseitigen Feldeffekttransistors einen durch das Referenzsignal $V_{REF}$ bestimmten Spannungswert annimmt. Somit kann beispielsweise durch das erste Eingangssignal $V_{INA}$ und das Referenzsignal $V_{REF}$ sowohl die Drain-Source-Spannung des eingangsseitigen Feldeffekttransistors T1_1 als auch der Drainstrom des eingangsseitigen Feldeffekttransistors T1_1 festgelegt werden, wobei die im Wesentlichen durch den ersten Operationsverstärker 534 gebildete Regelung die Gate-Source-Spannung des eingangsseitigen Feldeffekttransistors T1_1 so einstellt, bzw. so einregelt, dass sich die gewünschten Bedingungen ergeben. In anderen Worten, der Arbeitspunkt des eingangsseitigen Feldeffekttransistors T1_1 wird insbesondere auch durch die Einstellung bzw. Einregelung der Gate-Source-Spannung so festgelegt, dass sich ein durch das erste Eingangssignal $V_{INA}$ und das Referenzsignal $V_{REF}$ bestimmtes Verhältnis zwischen der Drain-Source-Spannung des eingangsseitigen Feldeffekttransistors und dem Drainstrom des eingangsseitigen Feldeffekttransistors ergibt. Ferner wird bevorzugt über eine entsprechende Dimensionierung (beispielsweise durch eine Begrenzung des Spannungsbereichs von $V_{REF}$) sichergestellt, dass der eingangsseitige Feldeffekttransistor T1_1 sich in einem linearen Bereich befindet, beispielsweise in dem Referenzsignal $V_{REF}$ geeignet eingestellt oder begrenzt wird.

Somit wird durch den Schaltungsblock 530 im Ergebnis ein Gate-Signal 532 erhalten, das Arbeitspunkte des eingangsseitigen Feldeffekttransistors T1_1 und auch des ausgangsseitigen Feldeffekttransistors T1_2 so einstellt, dass Verhältnisse zwischen einer jeweiligen Drain-Source-Spannung und einem jeweiligen Drainstrom durch das erste Eingangssignal $V_{INA}$ und durch das Referenzsignal $V_{REF}$ festgelegt werden.

Wird davon ausgegangen, dass der ausgangsseitige Feldeffekttransistor T1_2 dem eingangsseitigen Feldeffekttransistor T1_1 ausreichend ähnlich ist (insbesondere eine gleiche Schwellenspannung aufweist und auch im linearen Bereich betrieben wird), so ergibt sich, dass auch das Verhältnis zwischen der Drain-Source-Spannung des ausgangsseitigen Feldeffekttransistors T1_2 (oder T2) und dem Drainstrom des ausgangsseitigen Feldeffekttransistors T1_2 (oder T2) durch das erste Eingangssignal $V_{INA}$ und das Referenzsignal $V_{REF}$ festgelegt werden.

Der Schaltungsblock 540 ist ausgelegt, um die Drain-Source-Spannung des ausgangsseitigen Feldeffekttransistors auf einen Wert zu regeln, der beispielsweise durch das zweite Eingangssignal $V_{INB}$ festgelegt wird. Der zweite Schaltungsblock 540 umfasst beispielsweise einen zweiten Operationsverstärker 544. Ein nicht-invertierender Eingang 544a des zweiten Operationsverstärkers 544 ist beispielsweise mit dem zweiten Eingangssignal $V_{INB}$ gekoppelt. Ein invertierender Eingang 544b des zweiten Operationsverstärkers 544 ist beispielsweise derart mit dem Drain-Anschluss des ausgangsseitigen Feldeffekttransistors T1_2 (oder T2) gekoppelt, dass höchstens ein vernachlässigbarer Spannungsabfall zwischen dem Drain-Anschluss des ausgangsseitigen Feldeffekttransistors und dem invertierenden Eingang 544b des zweiten Operationsverstärkers 544 besteht. Ein Ausgang 544c des zweiten Operationsverstärkers 544 ist über einen zweiten Widerstand 546 (auch mit R2 bezeichnet) mit einem Knoten 548 gekoppelt, an dem der Drain-Anschluss des ausgangsseitigen Feldeffekttransistors T1_2 mit dem invertierenden Eingang 544b gekoppelt ist.

Durch die entsprechende Verschaltung regelt der zweite Operationsverstärker 544 die Drain-Source-Spannung des ausgangsseitigen Feldeffekttransistors T1_2 (oder T2) so, dass diese der Spannung des zweiten Eingangssignals $V_{INB}$ entspricht. Es ergibt sich dabei ein Drainstrom $I_D$ des ausgangsseitigen Feldeffekttransistors T1_2, der durch den oben beschriebenen (effektiven) Widerstand der Drain-Source-Strecke des ausgangsseitigen Feldeffekttransistors T1_2 in Verbindung mit der Drain-Source-Spannung des ausgangsseitigen Feldeffekttransistors T1_2 festgelegt wird. Der entsprechende Drainstrom des ausgangsseitigen Feldeffekttransistors T1_2 fließt durch den zweiten Widerstand 546 (R2), da davon ausgegangen werden kann, dass der in den invertierenden Eingang 544b des zweiten Operationsverstärkers 544 fließende Strom vernachlässigbar ist. Insofern wird das Ausgangssignal, das beispielsweise durch die an dem Ausgang 544c des zweiten Operationsverstärkers 544 anliegende Spannung bestimmt wird, im Wesentlichen durch den Drainstrom des ausgangsseitigen Feldeffekttransistors T1_2 bestimmt.

Im Ergebnis kann somit erreicht werden, dass das Ausgangssignal $V_{OUT}$ (definiert beispielsweise als die an dem Ausgang 544c des zweiten Operationsverstärkers 544 anliegende Spannung) auf einem Produkt zweier Spannungen basiert, die die Signale $V_{INA}$ und $V_{INB}$ darstellen. Ferner fließt das Referenzsignal beispielsweise als "Divisor" in das Ausgangssignal $V_{OUT}$ ein, so dass das Ausgangssignal $V_{OUT}$ umgekehrt proportional zu dem Referenzsignal $V_{REF}$ ist.

Weitere Details im Hinblick auf die Funktionsweise der Schaltungsanordnung 500 werden im Folgenden noch erläutert.

Ferner sei darauf hingewiesen, dass die hier beschriebene Schaltung 500 optional an alle Merkmale, Funktionalitäten und Details ergänzt werden kann, die hierin beschrieben sind, und zwar sowohl einzeln als auch in Kombination.

Ferner sei darauf hingewiesen, dass die Regelschaltungen natürlich strukturell modifiziert werden können, solange die wesentliche Funktionalität gegeben ist. Zudem können natürlich statt N-Kanal-Transistoren auch P-Kanal-Transistoren eingesetzt werden. Wenngleich der Einsatz von MOS-Feldeffekttransistoren bevorzugt wird, ist auch der Einsatz von anderen Typen von Feldeffekttransistoren denkbar. Entsprechende Modifikationen können natürlich auch in den anderen Ausführungsbeispielen gemacht werden.

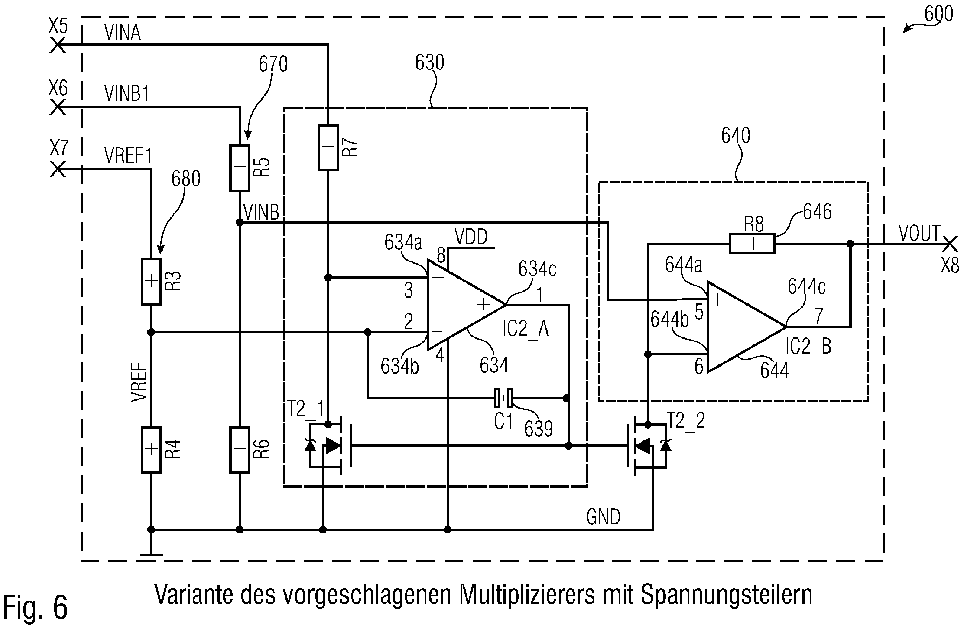

3. Ausführungsbeispiel gemäß Fig. 6

Fig. 6 zeigt ein Schaltbild einer Variante des vorgeschlagenen Multiplizierers mit Spannungsteilern.

Die Schaltungsanordnung gemäß Fig. 6 ist in ihrer Gesamtheit mit 600 bezeichnet und ähnelt sehr stark der Schaltungsanordnung 500 gemäß Fig. 5.

Insbesondere werden gleiche bzw. gleichwirkende Blöcke hier nicht noch einmal erläutert, sondern es wird auf die obigen Ausführungen im Hinblick auf die Fig. 5 verwiesen.

Die Schaltungsanordnung 600 ist ausgelegt, um ein erstes Eingangssignal $V_{INA}$ zu empfangen, das beispielsweise dem anhand der Fig. 5 beschriebenen Signal $V_{INA}$ entspricht. Ferner empfängt die Schaltungsanordnung 600 ein zweites Eingangssignal $V_{INB1}$ an einen zweiten Signaleingang, das beispielsweise durch einen (bevorzugt resistiven) Spannungsteiler, der zwischen den zweiten Signaleingang und ein Bezugspotenzial geschaltet ist, geteilt wird. An einem Abgriff des resistiven Spannungsteilers 670 kann ein Signal $V_{INB}$ abgegriffen werden, das beispielsweise dem anhand der Fig. 5 erläuterten Signal $V_{INB}$ entspricht. Die Schaltungsanordnung 600 empfängt ferner ein Referenzsignal $V_{REF1}$ an einem Referenzsignal-Eingang, und das an dem Referenzsignal-Eingang anliegende Signal $V_{REF1}$ wird durch einen (bevorzugt resistiven) Spannungsteiler 680, der zwischen den Referenzsignaleingang und das Bezugspotenzial geschaltet ist, heruntergeteilt. An dem Abgriff des resistiven Spannungsteilers 680 liegt somit ein heruntergeteiltes Referenzsignal $V_{REF}$ an, das beispielsweise dem anhand der Fig. 5 erläuterten Referenzsignal $V_{REF}$ entspricht.

Der Schaltungsblock 630 entspricht im Wesentlichen dem Schaltungsblock 530 und empfängt das erste Eingangssignal $V_{INA}$ und das heruntergeteilte Referenzsignal $V_{REF}$. Der Schaltungsblock 630 unterscheidet sich von dem Schaltungsblock 530 dadurch, dass zusätzlich eine Kapazität 639 zwischen dem Ausgang 634c des Operationsverstärkers 634 und den invertierenden Eingang 634b des Operationsverstärkers 634 geschaltet ist. Der Operationsverstärker 634 entspricht im Übrigen dem Operationsverstärker 534, der nicht-invertierende Eingang 634a des Operationsverstärkers 634 entspricht dem nicht-invertierenden Eingang 534a des Operationsverstärkers 534, der invertierende Eingang 634b des Operationsverstärkers 634 entspricht dem invertierenden Eingang 534b des Operationsverstärkers 534 und der Ausgang 634c des Operationsverstärkers 634 entspricht dem Ausgang 534c des Operationsverstärkers 534. Der eingangsseitige Feldeffekttransistor T2_1 entspricht im Übrigen dem in der Fig. 5 gezeigten eingangsseitigen Feldeffekttransistors T1_1.

Ferner umfasst die Schaltungsanordnung 600 einen ausgangsseitigen Feldeffekttransistor T2_2, der im Wesentlichen dem in der Fig. 5 gezeigten ausgangsseitigen Feldeffekttransistor T1_2 entspricht.

Der Schaltungsblock 640 entspricht von seiner Funktionalität her unverändert dem Schaltungsblock 540, wobei ein zweiter Operationsverstärker 644 dem zweiten Operationsverstärker 544 entspricht, wobei ein nicht-invertierender Eingang 644a dem nicht-invertierenden Eingang 544a entspricht, wobei ein invertierender Eingang 644b dem invertierenden Eingang 544b entspricht und wobei ein Ausgang 644c dem Ausgang 544c entspricht. Der Widerstand 646 entspricht dem Widerstand 546.

Zusammenfassend ist somit festzuhalten, dass die Schaltungsanordnung 600 im Wesentlichen der Schaltungsanordnung 500 entspricht, wobei der resistive Spannungsteiler 670 das zweite Eingangssignal $V_{INB1}$ beispielsweise derart herunterteilt, dass die Drain-Source-Spannung des ausgangsseitigen Feldeffekttransistors T2_2 ausreichend klein bleibt, so dass der ausgangsseitige Feldeffekttransistors T2_2 in dem linearen Betrieb betrieben wird. In ähnlicher Weise teilt der resistive Spannungsteiler 680 das Referenzsignal $V_{REF}$ derart herunter, dass die Drain-Source-Spannung des eingangsseitigen Feldeffekttransistors T2_1 ausreichend klein bleibt, so dass der eingangsseitige Feldeffekttransistor T2_1 in dem linearen Bereich betrieben wird.

Zusammenfassend ist somit festzuhalten, dass die Schaltungsanordnung 600 der Schaltungsanordnung 500 recht ähnlich ist.

Durch die resistiven Spannungsteiler 670, 680 wird erreicht, dass die Drain-Source-Spannungen des eingangsseitigen Feldeffekttransistors T2_1 und des ausgangsseitigen Feldeffekttransistors T2_2 ausreichend klein sind, um die entsprechenden Feldeffekttransistoren im linearen Bereich betreiben zu können, selbst wenn die Eingangssignale $V_{INB1}$ und $V_{REF1}$ vergleichsweise größer sind als die zulässigen Drain-Source-Spannungen, die es erlauben, die Transistoren im linearen Bereich zu betreiben. Die zusätzliche Kapazität 639 kann beispielsweise Regel-Eigenschaften verbessern, ist aber als optional anzusehen. Die Kapazität 639 könnte in entsprechender Weise auch in der Schaltungsanordnung 500 eingesetzt werden.

Ergänzend sei darauf hingewiesen, dass die Schaltungsanordnung in verschiedener Weise modifiziert werden kann. Beispielsweise können die Eingangsspannungen alternativ auch durch Ströme dargestellt werden. Im Übrigen könnte die Ableitung des Ausgangssignals $V_{OUT}$ auch in anderer Weise erfolgen.

Beispielsweise könnte auch ein Strom in den ausgangsseitigen Feldeffekttransistor eingeprägt werden, und es könnte die über den ausgangsseitigen Feldeffekttransistor abfallende Spannung ausgewertet werden, um das Ausgangssignal $V_{OUT}$ abzuleiten.

Im Übrigen kann die Schaltungsanordnung 600 optional um alle Merkmale, Funktionalitäten und Details ergänzt werden, die hierin offenbart sind, und zwar sowohl einzeln als auch in Kombination.

## 4. Weitere Erläuterungen zu dem Lösungsweg

Im Folgenden wird eine Lösung gemäß einem Ausführungsbeispiel der vorliegenden Erfindung noch einmal genauer erläutert.

Es sei darauf hingewiesen, dass ein Ausführungsbeispiel gemäß den vorliegenden Erläuterungen für sich genommen verwendet werden kann. Allerdings sei darauf hingewiesen, dass die im Folgenden noch beschriebenen Details optional in die übrigen hierin erläuterten Ausführungsbeispiele übernommen werden können, und zwar sowohl einzeln als auch in Kombination.

Es sei darauf hingewiesen, dass sich die im Folgenden gemachten Ausführungen und Erläuterungen im Wesentlichen auf das Ausführungsbeispiel gemäß der Fig. 5 beziehen. Die hier dargestellten Details können allerdings alternativ auch bei den Ausführungsbeispielen gemäß Fig. 1 und 6 eingesetzt werden, wobei natürlich die Eigenheiten der spezifischen Ausführungsbeispiele (beispielsweise das Vorhandensein der Spannungsteiler 670, 680) zu berücksichtigen wäre.

Fig. 5 zeigt eine Grundschaltung gemäß dem Konzept der vorliegenden Erfindung. Hier kommen ebenfalls - wie in Fig. 4 - Operationsverstärker zum Einsatz, die allerdings hier MOSFETs (Metall-Oxid-Halbleiter-Feldeffekttransistoren bzw. "Metal-Oxide-Semiconductor-Field-Effect Transistors") ansteuern. Dabei wird ausgenutzt, dass Feldeffekttransistoren bei kleiner Drain-Source-Spannung als gesteuerte Widerstände eingesetzt werden können. Laut Literatur sollte (bzw. muss) dabei folgender Zusammenhang zwischen Gate-Source-Spannung $V_{GS}$, Drain-Source-Spannung $V_{DS}$ und Schwellenspannung $V_{th}$ für die Feldeffekttransistoren gelten: $(V_{GS} - V_{th}) >= V_{DS}$. Dann ergibt sich in erster Näherung für den Drain-Source-Strom $I_{DS}$ und den Verstärkungsfaktor $K_n$ eines N-MOSFETs:

$$I_{DS} = K_n \cdot \left( (V_{GS} - V_{th}) \cdot V_{DS} \right)$$

$$(1)$$

Dementsprechend kann man in Fig. 5 die Ausgangsspannung $V_{OUT}$ unter Anwendung der üblichen Regeln für ideale Operationsverstärker herleiten:

$$\frac{V_{INA} - V_{Ref}}{R1} = K_1 \cdot (V_{GS} - V_{th}) \cdot V_{REF}$$

$$(2)$$

$$\frac{V_{OUT} - V_{INB}}{R2} = K_2 \cdot (V_{GS} - V_{th}) \cdot V_{INB}$$

$$(3)$$

Aus Gleichungen 2) und 3) folgt:

$$\frac{V_{OUT} - V_{INB}}{R2 \cdot V_{INB}} = \frac{V_{INA} - V_{REF}}{R1 \cdot V_{REF}}$$

$$(4)$$

Aus Gleichung 4) kann man bereits erkennen, dass die Transistor-Parameter in der Schaltung eliminiert werden können, falls die beiden Transistoren den gleichen technischen Aufbau und möglichst das gleiche Temperaturniveau haben. Voraussetzung ist also (bevorzugt, aber nicht notwendigerweise): $K_1 = K_2$.

Aus Gleichung 4) folgt weiterhin:

$$\frac{V_{OUT} - V_{INB}}{R2 \cdot V_{INB}} = \frac{V_{INA} - V_{REF}}{R1 \cdot V_{REF}}$$

$$\frac{V_{OUT}}{R2 \cdot V_{INB}} = \frac{V_{INA}}{R1 \cdot V_{REF}} - \frac{1}{R1} + \frac{1}{R2}$$

$$(5)$$

An dieser Stelle kann man (optional) weiter vereinfachen, indem man die Widerstandswerte gleichsetzt: $R_1$ = $R_2$. Folglich ergibt sich $V_{OUT}$:

$$V_{OUT} = \frac{V_{INA} \cdot V_{INB}}{V_{REF}}$$

$$(6)$$

Aus Gleichung 6) kann man erkennen, dass sich mit der vorgeschlagenen Schaltung die gewünschte Multiplikation zwischen den Eingangssignalen $V_{INA}$ und $V_{INB}$ ergibt. Außerdem kann man (optional) gleichzeitig eine Division durchführen, wenn man $V_{REF}$ als Eingangssignal und nicht als feste Größe ansieht. Dadurch können gemäß einem (optionalen) Aspekt der Erfindung durchaus je nach Anwendung gleichzeitig zwei Rechenschritte ausgeführt werden.

Eine Einschränkung ist dabei allerdings, dass $V_{REF}$ und $V_{INB}$ kleine Werte annehmen, da die beiden Spannungen gleichzeitig die Drain-Source-Spannungen der N-MOS-Transistoren darstellen und diese sonst nicht mehr im Linearbereich arbeiten.

Gemäß einem Aspekt der Erfindung kann dies aber durch Spannungsteiler sehr leicht erreicht werden, wie dies in der Schaltungsvariante in Fig. 6 dargestellt ist. Der (optionale) Kondensator C1 dient hierbei zur Stabilisierung, wenn der Ausgang des ersten Operationsverstärkers 634 (IC2_A) kleiner ist als die Schwellenspannung der Feldeffekttransistoren T2_1 und T2_2.

Ergänzend sei darauf hingewiesen, dass die hierin beschriebenen Schaltungsanordnungen deutlich verändert werden können.

im Hinblick auf die Feldeffekttransistoren ist festzuhalten, dass diese bei einem bevorzugten Ausführungsbeispiel gleichartig bzw. sogar vollkommen gleich sind. Allerdings ist dies nicht erforderlich. Vielmehr ist es ganz allgemein wünschenswert, dass die (effektiven) Widerstände der Drain-Source-Strecken zumindest zueinander proportional sind. Dies kann beispielsweise erreicht werden, indem sichergestellt wird, dass die Feldeffekttransistoren (also der eingangsseitige Feldeffekttransistor und der ausgangsseitige Feldeffekttransistor) gleiche Schwellenspannungen aufweisen. Um dies zu erreichen, ist es vorteilhaft, wenn die Feldeffekttransistoren gleiche Schichtenfolgen aufweisen und sich hier beispielsweise zumindest im Wesentlichen auf der gleichen Temperatur befinden. Gate-Längen und Gate-Breiten der Feldeffekttransistoren können hingegen unterschiedlich sein. Dies würde aber unter Umständen zu unterschiedlichen Werten von $K_1$ und $K_2$ führen, was allerdings nicht besonders problematisch wäre.

Im Übrigen könnten die Werte der Widerstände auch anders gewählt werden und müssen nicht zwangsläufig gleich sein. Ferner kann es abhängig von der Dimensionierung, beispielsweise der Transistoren und der Widerstände, vorteilhaft sein, ein oder mehrere der Eingangssignale mit einem beispielsweise konstanten Offset zu beaufschlagen und/oder beispielsweise einen Offset von dem Ausgangssignal zu subtrahieren. Auch dies ist schaltungstechnisch mit moderatem Aufwand möglich. Im Übrigen ist es nicht erforderlich, dass alle drei der Eingangssignale $V_{INA}$, $V_{INB}$ und $V_{REF}$ (bzw. $V_{INB1}$, $V_{REF1}$) tatsächlich verwendet werden. Vielmehr können beispielsweise auch nur zwei der entsprechenden Eingangssignale verwendet werden, so dass entweder eine Multiplikationsfunktion oder eine Divisionsfunktion ausgeführt wird. Optional können die Schaltungen beispielsweise auch so verändert werden, dass ein Kehrwert des Produkts zweier Signale berechnet wird.

Weitere Veränderungen der genannten Schaltungsanordnung sind allerdings auch möglich, wobei es vorteilhaft ist, beide Feldeffekttransistoren in einem linearen Bereich mit gleichen Gate-Source-Spannungen zu betreiben.

5. Vorteile von Ausführungsbeispielen der Erfindung

Zusammenfassend ist festzuhalten, dass Ausführungsbeispiele der vorliegenden Erfindung deutliche Vorteile gegenüber herkömmlichen Lösungen aufweisen. Es wurde erkannt, dass für bestimmte Anwendungen die beschriebene Gilbertzelle ungeeignet ist, da die Eingangssignale (siehe Fig. 2) in differenzieller Form vorliegen müssen, d. h. es können nur zwei Spannungsunterschiede verarbeitet werden. Dabei müssen Signale beispielsweise einen bestimmten Mittelwert haben, sonst gerät man außerhalb des Arbeitsbereichs der Transistoren bzw. der Anordnung. Ferner wurde erkannt, dass sich die Gilbertzelle - zusammen mit der äußeren Beschaltung - eventuell besser für integrierte Schaltungen gegenüber der beschriebenen Erfindung eignet, insbesondere aufgrund der höheren Bauteileanzahl.

In anderen Worten, Ausführungsbeispiele der vorliegenden Erfindung bieten beispielsweise den Vorteil, dass es nicht erforderlich ist, differenzielle Eingangssignale zu haben. Vielmehr können die Eingangssignale beispielsweise "unsymmetrische" Signale mit Bezug auf ein Bezugspotenzial sein. Ferner ist bei dem Erfindungskonzept die Anzahl der Bauteile vergleichsweise gering, so dass Ausführungsbeispiele der vorliegenden Erfindung gut für eine Realisierung mit diskreten Bauteilen geeignet sind. Die vorzugsweise verwendeten Operationsverstärker sind beispielsweise in kompakten Gehäuseformen und zu geringen Kosten verfügbar.

Gegenüber einer Lösung mit Operationsverstärkern aus Abbildung 4 ist der deutlich geringere Bauteileaufwand der erfindungsgemäßen Lösungen (beispielsweise gemäß den Fig. 5 und 6) erkennbar, wodurch sich schlussendlich auch ein geringerer Stromverbrauch realisieren lässt. In anderen Worten, ein nicht unwichtiger Vorzug von Ausführungsbeispielen gemäß der vorliegenden Erfindung liegt einerseits in der reduzierten Bauteilanzahl und andererseits in einem reduzierten Stromverbrauch.

Gegenüber der digitalen Variante bietet die Erfindung hauptsächlich einen Vorteil, nämlich dass keine Signalverzögerungen auftreten können und dabei von einer geringeren Stromaufnahme ausgegangen werden kann. In anderen Worten, Ausführungsbeispiele gemäß der vorliegenden Erfindung können das Ausgangssignal schnell und ohne eine Quantisierung oder Zeitdiskretisierung bereitstellen.

Gemäß einem Aspekt der vorliegenden Erfindung sind Ausführungsbeispiele besonders attraktiv für Schaltungen aus diskreten käuflichen Bauteilen - Operationsverstärker, Widerstände und MOS-Transistoren sind in großer Vielfalt verfügbar. Ausführungsbeispiele gemäß der vorliegenden Erfindung sind daher nicht nur als integrierte Schaltungen, sondern auch als diskrete Schaltungen ohne Weiteres realisierbar.

Ausführungsbeispiele gemäß der Erfindung lösen somit die Problemstellung elektrische Signale auf einfache Weise gegenüber dem Stand der Technik und mit Hilfe analoger Schaltungen multiplizieren oder dividieren zu können. Eine weitere Aufgabenstellung ist hierbei ein minimaler Stromverbrauch bei einer hohen Dynamik und Frequenz der Signale.

6. Technisches Anwendungsgebiet

Ein Ausführungsbeispiel gemäß der vorliegenden Erfindung wurde bereits in einer AC-DC-Wandler-Schaltung für einen elektrodynamischen Generator erfolgreich eingesetzt und getestet. Hierbei wurde beispielsweise ein Eingangswiderstand des AC-DC-Wandlers aus seiner Ausgangsspannung und seinem Ausgangsstrom bestimmt. Dabei war der Stromverbrauch entscheidend und konnte auf ca. 20 μA bei 1,8 V gebracht werden - wobei ein 50-Hz-Signal "in Echtzeit" kontinuierlich verarbeitet wurde. Dadurch kann eine Leistungsanpassung an den Generator erzielt werden, die mit Hilfe anderer gebräuchlicher Konzepte, wie "Maximum-Powerpoint-Tracking" (Nachverfolgung eines Punkts mit maximaler Leistung) nicht erreichbar war, u.a. durch die hohe Dynamik des Eingangssignals. Bei kleinerer Frequenz kann dieser Stromverbrauch weiter reduziert werden, beispielsweise durch Vergrößerung einiger Widerstandswerte oder durch Verwendung von Operationsverstärkern mit geringerer Leistungsaufnahme.

Allgemein sind Einsatzgebiete vor allem im Bereich der Leistungsmessung und -regelung - wie hierin beschrieben - denkbar, um die notwendige Strom-Spannungs-Multiplikation durchzuführen.

Allerdings sei darauf hingewiesen, dass Ausführungsbeispiele gemäß der vorliegenden Erfindung auch mit ganz anderen Anwendungen zum Einsatz kommen können, wobei beispielsweise die Geschwindigkeit der Schaltung durch geeignete Dimensionierung ohne größere Probleme angepasst werden kann.

Zusammenfassend ist somit zu sagen, dass Ausführungsbeispiele gemäß der Erfindung ein sehr universell einsetzbares Konzept zur Multiplikation bzw. Division von Eingangssignalen schaffen, das in den verschiedenen Anwendungen einsetzbar ist, und auch einen guten Kompromiss zwischen Leistungsfähigkeit und Realisierungsaufwand bietet.

7.Schlussfolgerungen und weitere Anmerkungen

Zusammenfassend ist festzuhalten, dass Ausführungsbeispiele gemäß der vorliegenden Erfindung eine vorteilhafte analoge Multiplizierer-/Dividiererschaltung schaffen.

Charakteristisch für Ausführungsbeispiele gemäß der Erfindung ist die Möglichkeit, auf einfache Weise elektrische analoge Signale miteinander multiplizieren oder dividieren zu können. Dadurch kann deutlich Energie eingespart werden gegenüber einer vergleichbaren digitalen Schaltung, da zudem die Digital-Analog-Konvertierung entfällt. In einem Ausführungsbeispiel wird die vorgeschlagene Architektur in einem Spannungswandler eingesetzt, um seinen Eingangswiderstand zu bestimmen und auf einen festen Wert zu regeln. Wenn in diesem Fall zum Beispiel ein elektrodynamischer Generator als Eingangsquelle benutzt wird, kann seine Induktivität direkt zur Aufwärtswandlung verwendet werden. Dadurch kann die Eingangsspannung des Wandlers nicht direkt gemessen werden. Es ist aber durch die beschriebene Erfindung möglich, aus den Ausgangsgrößen des Spannungswandlers auf seinen Eingang in analoger Weise zurückzurechnen. Dadurch kann im beschriebenen Anwendungsfall der Eingangswiderstand an den des Generators angepasst werden und so die maximale Energie aus dem Generator gewonnen und gespeichert werden.

Ausführungsbeispiele gemäß der Erfindung können im Kontext einer analogen Logikschaltung, eines Analogen Multiplizierers, eines Analogen Dividierers oder einer Operationsverstärker-Logikschaltung bzw. im Kontext der elektrischen Schaltungstechnik gesehen bzw. verwendet werden.

Ausführungsbeispiele gemäß der Erfindung können in einem AC/DC-Wandler mit Leistungsmanagement bzw. Powermanagement für Vibrations-Generatoren im Bereich "Energy Harvesting" ("Energie-Ernte") verwendet weden.

**Patentansprüche**

1. Eine Analogrechenschaltung (100,500;600),
   wobei die Analogrechenschaltung ausgelegt ist, um eine Gate-Source-Spannung ($U_{GS}$) eines ausgangsseitigen Feldeffekttransistors (120;T1_2; T2_2), der in einem linearen Bereich betrieben wird, in Abhängigkeit von zumindest einem Eingangssignal (110;VINA, $V_{INA}$.VREF, $V_{REF}$) einzustellen, und
   wobei die Analogrechenschaltung ausgelegt ist, um ein Ausgangssignal (114;VOUT, $V_{OUT}$) in Abhängigkeit von einem Stromfluss ($I_D$) durch den ausgangsseitigen Feldeffekttransistor (T1_2;T2_2) zu erhalten, wobei eine Drain-Source-Spannung ($V_{GS}$;$U_{GS}$) des ausgangsseitigen Feldeffekttransistors durch ein zweites Eingangssignal (114;VINB,$V_{INB}$) bestimmt wird, oder
   wobei die Analogrechenschaltung ausgelegt ist, um ein Ausgangssignal (114; VOUT, $V_{OUT}$) in Abhängigkeit von einer Drain-Source-Spannung ($V_{DS}$; $U_{DS}$) des ausgangsseitigen Feldeffekttransistors (120;T1_2;T2_2) zu erhalten, wobei ein Drainstrom ($I_D$) des ausgangsseitigen Feldeffekttransistors (120;T1_2;T2_2) durch ein zweites Eingangssignal (114;VINB,$V_{INB}$) bestimmt wird.

2. Analogrechenschaltung (100;500;600) gemäß Anspruch 1,
   wobei die Analogrechenschaltung einen eingangsseitigen Feldeffekttransistor (T1_1;T2_1) aufweist, der in einem linearen Bereich betrieben wird,
   wobei der eingangsseitige Feldeffekttransistor (T1_1 ;T2_1) und der ausgangsseitige Feldeffekttransistor (120;T1_2;T2_2) so verschaltet sind, dass Gate-Source Spannungen ($V_{GS}$;$U_{DS}$) des eingangsseitigen Feldeffekttransistors (T1_1;T2_1) und des ausgangsseitigen Feldeffekttransistors (120;T1_2;T2_2) gleich sind,
   wobei die Analogrechenschaltung ausgelegt ist, um die Feldeffekttransistoren (T1_1;T2_1; 120; T1_2; T2_2) so anzusteuern, dass eine Drain-Source-Spannung ($V_{DS}$;$U_{DS}$) des eingangsseitigen Feldeffekttransistors (T1_1;T2_1) und/oder ein Drainstrom ($I_D$) des eingangsseitigen Feldeffekttransistors (T1_1;T2_1) **durch zumindest ein Eingangssignal** (120;VINA,$V_{INA}$,VREF,$V_{REF}$) bestimmt werden.

3. Analogrechenschaltung (100;500;600) gemäß Anspruch 2,
   wobei die Analogrechenschaltung ausgelegt ist, um die Feldeffekttransistoren (T1_1; T2_1; 120; T1_2; T2_2) so anzusteuern, dass die Drain-Source-Spannung ($V_{DS}$;$U_{Ds}$) des eingangsseitigen Feldeffekttransistors (T1_1; T2_1) und der Drainstrom ($I_D$) des eingangsseitigen Feldeffekttransistors (T1_1; T2_1) durch **zwei Eingangssignale** (110; VINA, $V_{INA}$, VREF, $V_{REF}$) bestimmt werden.

4. Analogrechenschaltung (100;500;600) gemäß Anspruch 2 oder 3,
   wobei die Analogrechenschaltung so ausgelegt ist, dass ein Verhältnis zwischen einer Drain-Source-Spannung ($V_{DS}$, $U_{DS}$) des eingangsseitigen Feldeffekttransistors (T1_1; T2_1) und einem Drainstrom ($I_D$) des eingangsseitigen Feldeffekttransistors (T1_1; T2_1) zumindest näherungsweise gleich einem Verhältnis zwischen einer Drain-Source-Spannung ($V_{DS}$,$U_{DS}$) des ausgangsseitigen Feldeffekttransistors (120;T1_2;T2_2) und einem Drainstrom ($I_D$) des ausgangsseitigen Feldeffekttransistors (120;T1_2;T2_2) ist, oder
   wobei die Analogrechenschaltung so ausgelegt ist, dass ein Verhältnis zwischen einer Drain-Source-Spannung ($V_{DS}$, $U_{DS}$) des eingangsseitigen Feldeffekttransistors (T1_1; T2_1) und einem Drainstrom ($I_D$) des eingangsseitigen Feldeffekttransistors (T1_1; T2_1) zumindest näherungsweise proportional zu einem Verhältnis zwischen einer Drain-Source-Spannung ($V_{DS}$,$U_{DS}$) des ausgangsseitigen Feldeffekttransistors (120;T1_2;T2_2) und einem Drainstrom ($I_D$) des ausgangsseitigen Feldeffekttransistors (120;T1_2;T2_2) ist.

5. Analogrechenschaltung (100;500;600) gemäß einem der Ansprüche 2 bis 4,
   wobei die Analogrechenschaltung ausgelegt ist, um ein Verhältnis zwischen einer Drain-Source-Spannung

($V_{DS},U_{DS}$) des eingangsseitigen Feldeffekttransistors (T1_1; T2_1) und einem Drainstrom ($I_D$) des eingangsseitigen Feldeffekttransistors (T1_1; T2_1) in Abhängigkeit von zumindest einem Eingangssignal (110;VINA,$V_{INA}$,VREF,$V_{REF}$) einzustellen.

6. Analogrechenschaltung (100;500;600) gemäß einem der Ansprüche 2 bis 5,
   wobei die Analogrechenschaltung ausgelegt ist, um ein Verhältnis ($V_{DS}$(T1_1)/$I_D$(T1_1); $V_{DS}$(T2_1)/$I_D$(T2_1)) zwischen einer Drain-Source-Spannung ($V_{DS},U_{DS}$) des eingangsseitigen Feldeffekttransistors (T1_1; T2_1) und einem Drainstrom ($I_D$) des eingangsseitigen Feldeffekttransistors (T1_1; T2_1) so einzustellen, dass das Verhältnis zwischen der Drain-Source-Spannung des eingangsseitigen Feldeffekttransistors und dem Drainstrom des eingangsseitigen Feldeffekttransistors eine lineare Abhängigkeit von einem der Eingangssignale (VREF,$V_{REF}$) aufweist, und/oder
   wobei die Analogrechenschaltung ausgelegt ist, um ein Verhältnis ($I_D$(T1_1)/$V_{DS}$(T1_1); $I_D$(T2_1)/$V_{DS}$(T2_1)) zwischen dem Drainstrom ($I_D$) des eingangsseitigen Feldeffekttransistors (T1_1; T2_1) und der Drain-Source-Spannung ($V_{DS}$;$U_{Ds}$) des eingangsseitigen Feldeffekttransistors (T1_1; T2_1) so einzustellen, dass das Verhältnis zwischen dem Drainstrom des eingangsseitigen Feldeffekttransistors und der Drain-Source-Spannung des eingangsseitigen Feldeffekttransistors eine lineare Abhängigkeit von einem der Eingangssignale (VINA,$V_{INA}$) aufweist.

7. Analogrechenschaltung (100;500;600) gemäß einem der Ansprüche 2 bis 6,
   wobei die Analogrechenschaltung ausgelegt ist, um den eingangsseitigen Feldeffekttransistor (T1_1; T2_1) so anzusteuern, dass eine Drain-Source-Spannung ($V_{DS},U_{DS}$) des eingangsseitigen Feldeffekttransistors eine lineare Abhängigkeit von einem der Eingangssignale (VREF,$V_{REF}$) aufweist oder konstant ist; und/oder
   wobei die Analogrechenschaltung ausgelegt ist, um den eingangsseitigen Feldeffekttransistor (T1_1; T2_1) so anzusteuern, dass ein Drainstrom ($I_D$) des eingangsseitigen Feldeffekttransistors eine lineare Abhängigkeit von einem der Eingangssignale (110;VINA,$V_{INA}$) aufweist oder konstant ist.

8. Analogrechenschaltung (100;500;600) gemäß einem der Ansprüche 1 bis 7,
   wobei die Analogrechenschaltung so ausgelegt ist, dass eine lineare Abhängigkeit zwischen einem Drain-Strom ($I_D$) des ausgangsseitigen Feldeffekttransistors (120;T1_2;T2_2) und dem Ausgangssignal (114;VOUT;$V_{OUT}$) besteht.

9. Analogrechenschaltung (100;500;600) gemäß einem der Ansprüche 1 bis 8,
   wobei die Analogrechenschaltung ausgelegt ist, um den ausgangsseitigen Feldeffekttransistor (120;T1_2;T2_2) so anzusteuern, dass ein Zusammenhang zwischen einem Drain-Strom ($I_D$) des ausgangsseitigen Feldeffekttransistors und einer Drain-Source-Spannung ($V_{DS}$;$U_{DS}$) des ausgangsseitigen Feldeffekttransistors durch zumindest ein Eingangssignal (110;VINA;$V_{INA}$; VREF;$V_{REF}$) bestimmt wird.

10. Analogrechenschaltung (100;500;600) gemäß einem der Ansprüche 1 bis 9,
    wobei die Analogrechenschaltung ausgelegt ist, um den ausgangsseitigen Feldeffekttransistor (120;T1_2;T2_2) so anzusteuern, dass ein Verhältnis zwischen der Drain-Source-Spannung ($V_{DS}$;$U_{DS}$) des ausgangsseitigen Feldeffekttransistors (120;T1_2;T2_2) und dem Drainstrom ($I_D$) des ausgangsseitigen Feldeffekttransistors (120;T1_2;T2_2) zumindest näherungsweise eine lineare Abhängigkeit von einem der Eingangssignale (VREF, $V_{REF}$) aufweist, und/oder
    wobei die Analogrechenschaltung ausgelegt ist, um den ausgangsseitigen Feldeffekttransistor (120;T1_2;T2_2) so anzusteuern, dass ein Verhältnis zwischen dem Drainstrom ($I_D$) des ausgangsseitigen Feldeffekttransistors (120;T1_2;T2_2) und der Drain-Source-Spannung ($V_{DS}$;$U_{DS}$) des ausgangsseitigen Feldeffekttransistors (120;T1_2;T2_2) zumindest näherungsweise eine lineare Abhängigkeit von einem der Eingangssignale (110; VINA;$V_{INA}$) aufweist.

11. Analogrechenschaltung (100;500;600) gemäß einem der Ansprüche 1 bis 10,
    wobei die Analogrechenschaltung einen eingangsseitigen Feldeffekttransistor (T1_1;T2_1) aufweist,
    wobei die Analogrechenschaltung einen ersten Operationsverstärker (534;634) aufweist, der ausgelegt ist, um eine Gate-Source-Spannung ($V_{GS}$;$U_{GS}$) des eingangsseitigen Feldeffekttransistors (T1_1;T2_1) einzustellen, um die Drain-Source-Spannung ($V_{DS}$;$U_{Ds}$) des eingangsseitigen Feldeffekttransistors (T1_1;T2_1) auf einen vorgegebenen Wert zu regeln.

12. Analogrechenschaltung (100;500;600) gemäß Anspruch 11,
    wobei der Operationsverstärker (534;634) ausgelegt ist, um die Drain-Source-Spannung ($V_{DS}$;$U_{DS}$) des eingangsseitigen Transistors (T1_1;T2_1) auf einen vorgegebenen Wert zu regeln, wobei ein Drainstrom ($I_D$) des eingangsseitigen Feldeffekttransistors (T1_1;T2_1) durch ein Eingangssignal (110;VINA;$V_{INA}$) bestimmt wird.

13. Analogrechenschaltung (100;500;600) gemäß einem der Ansprüche 1 bis 12, wobei die Analogrechenschaltung einen zweiten Operationsverstärker (544;644) aufweist, der ausgelegt ist, um eine Drain-Source-Spannung ($V_{DS}$;$U_{Ds}$) des ausgangsseitigen Feldeffekttransistors (120;T1_2;T2_2) auf einen Spannungswert zu regeln, der durch das zweite Eingangssignal (114;VINB;$V_{INB}$) bestimmt wird.

14. Analogrechenschaltung (100;500;600) gemäß einem der Ansprüche 1 bis 13, wobei die Analogrechenschaltung einen eingangsseitigen Feldeffekttransistor (T1_1;T2_1), einen ersten Operationsverstärker (534;634) und einen zweiten Operationsverstärker (544;644) aufweist, wobei ein erster Eingang (534a;634a) des ersten Operationsverstärkers (534;634) mit einem ersten Signaleingang (110,-VINA,$V_{INA}$) und mit einem Drain-Anschluss (D) des eingangsseitigen Feldeffekttransistors (T1_1;T2_1) gekoppelt ist, wobei ein zweiter Eingang (534b;634b) des ersten Operationsverstärkers (534;634) mit einem vorgegebenen Referenzsignal (VREF;$V_{REF}$) oder mit einem weiteren Signaleingang gekoppelt ist, wobei ein Ausgang (534c;634c) des ersten Operationsverstärkers (534;634) mit einem Gate-Anschluss (G) des eingangsseitigen Feldeffekttransistors (T1_1;T2_1) und mit einem Gate-Anschluss (G) des ausgangsseitigen Feldeffekttransistors (120;T1_2;T2_2) gekoppelt ist, wobei Source-Anschlüsse (S) des eingangsseitigen Feldeffekttransistors (T1_1;T2_1) und des ausgangseitigen Feldeffekttransistors (120;T1_2;T2_2) miteinander gekoppelt sind, wobei ein erster Eingang (544a;644a) des zweiten Operationsverstärkers (544;644) mit einem zweiten Signaleingang (VINB;$V_{INB}$) gekoppelt ist, wobei ein zweiter Eingang (544b;644b) des zweiten Operationsverstärkers (544;644) mit einem Drain-Anschluss (D) des ausgangsseitigen Feldeffekttransistors (120;T1_2;T2_2) gekoppelt ist, und wobei die Analogrechenschaltung einen Widerstand (546;646) aufweist, der zwischen den Drain-Anschluss (D) des ausgangsseitigen Feldeffekttransistors (120;T1_2;T2_2) und einen Ausgang (544c;644c) des zweiten Operationsverstärkers (544;644) geschaltet ist; und wobei der Ausgang (544c;644c) des zweiten Operationsverstärkers (544;644) mit einem Signalausgang (VOUT;$V_{OUT}$) gekoppelt ist.

Fig. 1

EP 3 828 753 A1

IF Ausgang

Q1  Q4  Q3  Q5

LO-Eingang

Q2  Q6

RF-Eingang

I1

Schaltung einer Gitterzelle

Fig. 2

$V_1 \rightarrow$ log(.)

$V_1 \rightarrow$ log(.)

$\Sigma$

$e^{(.)}$

$\rightarrow V_{out}$

alternativer Lösungsweg über Logarithmusfunktion

Fig. 3

Standardschaltung mit Operationsverstärkern zur Multiplizierung von Signalen

Fig. 4

EP 3 828 753 A1

Grundschaltung eines Multiplizierers mit gesteuerten MOS-Transistoren

Fig. 5

Fig. 6

Variante des vorgeschlagenen Multiplizierers mit Spannungsteilern

Europäisches
Patentamt

European
Patent Office

Office européen
des brevets

**EUROPÄISCHER RECHERCHENBERICHT**

Nummer der Anmeldung

EP 20 21 0397

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2003/005018 A1 (KAWAUCHI SHUHEI [JP]) 2. Januar 2003 (2003-01-02) * Abbildung 1 * ----- | 1-14 | INV. G06G7/16 H03F3/45 |
| X | Anonymous: "Simple Analog Multiplier Circuit Using LM107 under Repository-circuits -23208- : Next.gr", , 10. November 2019 (2019-11-10), Seiten 1-9, XP055788977, INTERNET Gefunden im Internet: URL:https://web.archive.org/web/2019111011 4456/http://www.next.gr/circuits/Simple-An alog-Multiplier-Circuit-Using-LM107-123208 .html [gefunden am 2021-03-23] * Abbildung 1 * ----- | 1-14 | |
| A | LAWRENCE MAYES: "The Field Effect Transistor as a Voltage Controlled Resistor", INTERNET CITATION, 18. Oktober 2002 (2002-10-18), Seiten 1-3, XP002688976, Gefunden im Internet: URL:http://freespace.virgin.net/ljmayes.ma l/comp/vcr.htm [gefunden am 2012-12-07] * das ganze Dokument * ----- | 1-14 | RECHERCHIERTE SACHGEBIETE (IPC) G06G G06N H03F |

Der vorliegende Recherchenbericht wurde für alle Patentansprüche erstellt

| Recherchenort | Abschlußdatum der Recherche | Prüfer |
|---|---|---|
| Den Haag | 24. März 2021 | Simon, Volker |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.....................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 20 21 0397

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-03-2021

| Im Recherchenbericht angeführtes Patentdokument | Datum der Veröffentlichung | Mitglied(er) der Patentfamilie | Datum der Veröffentlichung |
|---|---|---|---|
| US 2003005018 A1 | 02-01-2003 | JP 2003016379 A<br>US 2003005018 A1 | 17-01-2003<br>02-01-2003 |

Für nähere Einzelheiten zu diesem Anhang : siehe Amtsblatt des Europäischen Patentamts, Nr.12/82